# EUROPÄISCHE PATENTSCHRIFT

(11) **EP 3 912 198 B1**
(45) Veröffentlichungstag und Bekanntmachung des Hinweises auf die Patenterteilung: **18.03.2026**
(21) Anmeldenummer: 20700818.6
(22) Anmeldetag: 14.01.2020
(51) Int. Cl.: H10H 20/858, B41J 2/45

(54) **LICHTQUELLE MIT MINDESTENS EINEM ERSTEN LICHTEMITTIERENDEN HALBLEITERBAUELEMENT, EINEM ERSTEN TRÄGERELEMENT UND EINEM VERTEILERELEMENT**
LIGHT SOURCE WITH AT LEAST A LIGHT EMITTING SEMICONDUCTOR ELEMENT, A FIRST CARRIER ELEMENT AND A DISTRIBUTING ELEMENT
SOURCE DE LUMIÈRE COMPRENANT AU MOINS UN ÉLÉMENT SEMI-CONDUCTEUR ÉLECTROLUMINESCENT, UN PREMIER ÉLÉMENT DE SUPPORT ET UN ÉLÉMENT DISTRIBUTEUR

(30) Priorität: 16.01.2019 DE 102019200478
(43) Veröffentlichungstag der Anmeldung: 24.11.2021
(73) Patentinhaber: Excelitas Noblelight GmbH, 63755 Alzenau (DE)
(72) Erfinder: MEYER, Stefan, 63755 Alzenau (DE); GRADE, Jochen, 63755 Alzenau (DE); WEWER, Nico, 63755 Alzenau (DE); STAHL, Andreas, 63755 Alzenau (DE); DESGRONTE, Janek, 63755 Alzenau (DE)
(74) Vertreter: Herzog IP Patentanwalts GmbH
(86) Internationale Anmeldenummer: PCT/EP2020/050826
(87) Internationale Veröffentlichungsnummer: WO 2020/148289

(56) Entgegenhaltungen:
- DE-A1- 102006 016 529
- DE-A1- 102006 016 529
- DE-A1- 102011 082 317
- DE-A1- 102011 082 317
- JP-A- 2005 079 065
- JP-A- 2005 079 065
- US-A1- 2007 084 585
- US-A1- 2009 039 380
- US-A1- 2009 039 380
- US-A1- 2009 039 502
- US-A1- 2011 037 390
- US-A1- 2011 037 390

## Beschreibung

Die vorliegende Erfindung betrifft eine Lichtquelle, beinhaltend als einander in dieser Reihenfolge überlagernde Bauteile
a) mindestens ein erstes lichtemittierendes Halbleiterbauelement;
b) ein erstes Trägerelement, beinhaltend
   i) eine dem mindestens einen ersten lichtemittierenden Halbleiterbauelement zugewandte erste Trägeroberfläche, und
   ii) zusätzlich eine erste Kühloberfläche; und
c) ein Verteilerelement, beinhaltend
   i) einen ersten Hohlraum, und
   ii) einen weiteren Hohlraum;
wobei der erste Hohlraum und der weitere Hohlraum fluidleitend mittels eines ersten Fluidwegs miteinander verbunden sind; wobei der erste Fluidweg mindestens teilweise durch die erste Kühloberfläche begrenzt wird; wobei die erste Trägeroberfläche und die erste Kühloberfläche einander gegenüberliegende äußere Oberflächen des ersten Trägerelements sind; wobei das Verteilerelement in einer longitudinalen Richtung längserstreckt ist; wobei der erste Hohlraum
a] einen ersten Kanal beinhaltet, der sich in der longitudinalen Richtung längserstreckt, und
b] zusätzlich einen zweiten Kanal, der sich von dem ersten Kanal in Richtung des ersten Trägerelements längserstreckt,
wobei der erste Kanal und der zweite Kanal des ersten Hohlraums fluidleitend miteinander verbunden sind, wobei ein Durchmesser des ersten Kanals des ersten Hohlraums mehr ist als ein Durchmesser des zweiten Kanals des ersten Hohlraums; wobei der weitere Hohlraum
a} einen ersten Kanal beinhaltet, der sich in der longitudinalen Richtung längserstreckt, und
b} zusätzlich einen zweiten Kanal, der sich von dem ersten Kanal in Richtung des ersten Trägerelements längserstreckt,
wobei der erste Kanal und der zweite Kanal des weiteren Hohlraums fluidleitend miteinander verbunden sind, wobei ein Durchmesser des ersten Kanals des weiteren Hohlraums mehr ist als ein Durchmesser des zweiten Kanals des weiteren Hohlraums. Ferner betrifft die Erfindung eine Druckmaschine; Verfahren, insbesondere zum Herstellen eines Druckerzeugnisses, zum Bestrahlen eines Bestrahlungsguts, und zum Herstellen einer Lichtquelle; eine Anordnung mit der erfindungsgemäßen Lichtquelle; und Verwendungen der erfindungsgemäßen Lichtquelle.

Im technischen Gebiet der Erfindung - der Druckindustrie - ist die Verwendung von Lichtquellen zum Aushärten von Druckfarben und Lacken seit Langem bekannt. Ferner ist die Verwendung von UV-härtbaren Farben und Lacken - also Farben und Lacken, die durch Bestrahlen mit geeigneter ultravioletter Strahlung gehärtet werden können - bekannt. Herkömmlicherweise werden zum Härten solcher Farben und Lacke Quecksilberdampflampen eingesetzt. Diese Lichtquellen zeigen jedoch beispielsweise hinschlich ihrer Lebensdauer, Wartungsintensität und auch Wärmeentwicklung erhebliche Nachteile. Dies wurde im Stand der Technik bereits erkannt. In der Folge werden immer häufiger lichtemittierende Halbleiterbauelemente, insbesondere Leuchtdioden-Module (LED-Module), an Stelle von Quecksilberdampflampen zum Bestrahlen UV-härtbarer Farben und Lacke eingesetzt. Obgleich die Verwendung von Leuchtdioden bereits viele Vorteile gegenüber den altbekannten Quecksilberdampflampen eröffnet, besteht für die Ausgestaltung von Lichtquellen mit LED, insbesondere aber nicht ausschließlich mit UV-LED, Raum zur Verbesserung. So werden in der Druckindustrie häufig Hochleistungsleuchtdioden eingesetzt, die trotz des für Leuchtdioden gegenüber Dampflampen typischen deutlich höheren Wirkungsgrads Abwärme erzeugen, welche abgeführt werden muss. Gelingt dies nicht in ausreichendem Maße, verringert sich der Wirkungsgrad der Leuchtdioden erheblich. Zudem kann die Lebensdauer der Leuchtdioden verkürzt werden. Bei nicht ausreichender Kühlung von Leuchtdioden werden also wesentliche Vorteile von Leuchtdioden gegenüber Dampflampen eingebüßt. Dies muss nicht nur für einzelne Leuchtdioden, sondern über möglichst alle Leuchtdioden einer Lichtquelle verhindert werden. Hierzu müssen möglichst alle Leuchtdioden einer Lichtquelle, die eine Länge in der Größenordnung von Metern haben kann, möglichst homogen gekühlt werden. Um sich diesem Ziel zu nähern, sind im Stand der Technik verschiedene Maßnahmen bekannt.

In WO 2017/008042 A1 wird ein Leuchtdiodenmodul beschriebenen, das ein durch Strangformen erhaltenen Träger beinhaltet, auf dem die Leuchtdiodenpakete des Moduls, also die Leuchtdioden, beinhaltend LED-Chips auf einem Substrat, montiert sind. Der Träger weist in seinem Inneren einen Durchgang auf, der zum Kühlen der LED mit einer Kühlflüssigkeit durchströmt werden kann. Da die Kühlung bei einem solchen Aufbau nicht sehr effizient ist, muss hier ein leistungsstarker und damit kosten- und energieintensiver Kühlreislauf verwendet werden, um dies auszugleichen.

Um die Effizienz der Kühlung zu erhöhen sind im Stand der Technik ferner Träger für LED-Module bekannt, die in ihrem Inneren nicht lediglich einen einfachen Durchgang, sondern eine sehr feine Kühlstruktur aus einer Vielzahl miteinander verbundener Mikro- und Makrokanäle aufweisen. Solche Träger werden oftmals aus einer Vielzahl von Kupferschichten aufgebaut, die in der Herstellung dicht miteinander verbunden werden müssen. Diese spezielle Herstellung ist sehr aufwendig und entsprechend teuer. Ferner ist die Wanddicke solcher Träger recht gering. Hierdurch ist die filigrane Kühlstruktur mechanisch nicht sehr belastbar, so dass es bei Druckspitzen im Kühlkreislauf zu Schäden kommen kann. Auch beim Montieren der LED auf den Träger kann es bereits zur Beschädigung des Trägers kommen. Ferner ergeben sich aus dem speziellen und aufwendigen Herstellungsverfahren Fertigungstoleranzen, die für einige Anforderungen zu groß sind.

US 2011/037390 A1 lehrt eine Beleuchtungsvorrichtung zur Bereitstellung von Licht mit Mischungen aus verschiedenen Farbtemperaturen und Intensitäten. Die Vorrichtung beinhaltet ein Gehäuse, enthaltend: eine Multi-Chip-LED zur Abgabe von Mischungen von Farbtemperaturen und Lichtintensitäten, mit einer mit einer Vielzahl von Blöcken von LEDs, die jeweils eine vorbestimmte Farbtemperatur haben, wobei die Multi-Chip-LED auf einer bedruckten Leiterplatte (PCB) montiert ist; ein Kühlsystem, das auf der Rückseite des PCB angebracht ist, wobei das Kühlsystem ein flüssiges Kühlmittel verwendet, um die von der Multi-Chip-LED erzeugte Wärme abzuführen; und ein Steuersystem, das elektrisch mit der Leiterplatte jedes Blocks und dem Kühlsystem verbunden ist, wobei das Steuersystem geeignet ist, die Multi-Chip-LED mit Strom zu versorgen und die Blöcke der LEDs auszuwählen, um die Farbtemperatur und die Lichtintensität, um die Mischungen zu erhalten.

JP 2005 079065 A betrifft eine Lichtquellenvorrichtung, die in der Lage ist, eine Festkörperlichtquelle mit hoher Effizienz zu kühlen, selbst wenn eine große Menge an Wärme von der Festkörperlichtquelle in einem kleinen Wärmeerzeugungsbereich generiert wird. Die Lichtquellenvorrichtung umfasst eine Festkörperlichtquelle und ein Basismaterial, auf dem die Festkörperlichtquelle montiert ist. Das Basismaterial ist auf einer Oberfläche der Festkörperlichtquelle vorgesehen, die einer Montagefläche gegenüberliegt. Die Oberfläche ist uneben ausgebildet.

Ferner lehrt US 2009/039380 A1 ein LED-Paket mit einem Basissubstrat, das eine Metallplatte ist, die elektrisch die mit einer Elektrode einer UV-LED verbunden ist und ein Abdeckungssubstrat, das eine Metallplatte ist, die elektrisch mit der anderen Elektrode verbunden ist und auf das Basissubstrat gestapelt ist. Eine Vielzahl von LED-Paketen ist so auf einem Header montiert, dass Mittellinien der Basissubstrate, die sich in ihrer Breitenrichtung erstrecken, zueinander ausgerichtet sind.

In DE 10 2006 016529 A1 wird eine flüssigkeitsgekühlte Halbleiter-Strahlungsquelle hoher Ausgangsleistung mit einem möglichst wirksamen Schutz gegen Schädigung oder gar Zerstörung der Strahlungsquelle durch verminderte Kühlleistung offenbart. Hier befindet sich ein Temperatursensor in direktem Kontakt mit einem Kühlmittel und vermag daher Temperaturänderungen mit geringstmöglicher Verzögerung zu detektieren. Der Temperatursensor ist beheizt, wobei eine Änderung seiner Temperatur ein Maß für die Strömungsgeschwindigkeit des Kühlmittels ist.

Allgemein ist es eine Aufgabe der vorliegenden Erfindung, einen Nachteil, der sich aus dem Stand der Technik ergibt, zumindest teilweise zu überwinden.

Eine weitere Aufgabe der Erfindung ist es, eine Lichtquelle für eine Druckmaschine bereitzustellen, wobei die Lichtquelle ein räumlich möglichst homogenes Aushärten einer Druckfarbe oder eines Lacks über eine möglichst große Fläche mittels Bestrahlen mit Licht aus lichtemittierenden Halbleiterbauelementen, insbesondere Leuchtioden, ermöglicht. Gemäß einer weiteren Aufgabe kann das vorgenannte Aushärten möglichst schnell erfolgen. Gemäß einer weiteren Aufgabe der Erfindung ermöglicht die erfindungsgemäße Lichtquelle das vorgenannte Aushärten unter Verwendung einer möglichst wenig aufwendigen Kühlung, vorzugsweise einem Kühlkreislauf mit möglichst geringem Druck. Eine weitere Aufgabe der Erfindung ist es, eine Lichtquelle für eine Druckmaschine bereitzustellen, wobei die Lichtquelle möglichst flexibel mit möglichst geringem Aufwand an eine auszuhärtende Farbe oder einen Lack angepasst werden kann. Ferner ist es eine Aufgabe der Erfindung, eine möglichst einfach zu wartende oder nachrüstbare oder beides Lichtquelle zum Aushärten einer Farbe oder eines Lacks in einer Druckmaschine bereitzustellen. Ferner ist es eine Aufgabe der Erfindung, eine der vorgenannten vorteilhaften Lichtquellen bereitzustellen, wobei diese zusätzlich mechanisch möglichst stabil ist. Dies betrifft insbesondere einen Kühlkörper der Lichtquelle. Bevorzugt neigt diese Lichtquelle ferner möglichst wenig dazu, bei ihrer Herstellung beschädigt zu werden, insbesondere bei einem Montieren von lichtemittierenden Halbleiterbauelementen auf einem Kühlkörper, beispielsweise durch ein Fügeverfahren wie Löten, Kleben oder Sintern. Ferner bevorzugt zeigt die erfindungsgemäße Lichtquelle eine möglichst geringe Neigung zu Beschädigungen bei hohen Drucken in einem Kühlkreislauf oder bei Druckspitzen in dem Kühlkreislauf zur Kühlung der lichtemittierenden Halbleiterbauelemente der Lichtquelle. Eine weitere Aufgabe der Erfindung ist es, eine Lichtquelle für eine Druckmaschine bereitzustellen, wobei die Lichtquelle möglichst einfach und kostengünstig herstellbar ist. Bevorzugt ist die Lichtquelle, insbesondere ein Kühlkörper der Lichtquelle, möglichst weitgehend unter Verwendung konventioneller Werkzeuge, wie beispielsweise einer CNC-Fräsmaschine, herstellbar. Ferner ist es eine Aufgabe der Erfindung, eine der vorgenannten vorteilhaften Lichtquellen bereitzustellen, wobei diese zusätzlich mit möglichst geringen Fertigungstoleranzen herstellbar ist. Eine weitere Aufgabe der Erfindung ist es, eine der vorgenannten vorteilhaften Lichtquellen bereitzustellen, wobei in der Herstellung der Lichtquelle ein Montieren der lichtemittierende Halbleiterbauelement auf einen Kühlkörper, insbesondere durch Löten oder Sintern, möglichst einfach ist. Eine weitere Aufgabe der Erfindung ist es, eine Lichtquelle für eine Druckmaschine bereitzustellen, wobei möglichst viele Komponenten der Lichtquelle möglichst gut wiederverwertbar, insbesondere rezyklierbar, sind. Bei allen vorgenannten vorteilhaften Lichtquellen handelt es sich bevorzugt um Halbleiterlichtquellen.

Weiter ist es eine Aufgabe der Erfindung, eine eine der vorstehend beschriebenen vorteilhaften Lichtquellen beinhaltende Druckmaschine bereitzustellen. Demnach zeigt diese Druckmaschine vorzugsweise einen oder mehrere der vorstehend für die Lichtquelle beschriebenen Vorteile.

Ferner ist es eine Aufgabe der Erfindung, ein Verfahren zur Herstellung einer Lichtquelle für eine Druckmaschine bereitzustellen, das sich durch eine vorteilhafte Kombination aus geringer Fertigungszeit, hoher Prozessstabilität, geringem Werkzeugverschleiß und einfacher mechanische Bearbeitung von verwendeten Werkstoffen für einen Kühlkörper, bevorzugt Kupfer oder Aluminium, auszeichnet.

Ein Beitrag zur mindestens teilweisen Erfüllung mindestens einer, vorzugsweise mehrerer, der obigen Aufgaben wird durch die unabhängigen Ansprüche geleistet. Die abhängigen Ansprüche stellen bevorzugte Ausführungsformen bereit, die zur mindestens teilweisen Erfüllung mindestens einer der Aufgaben beitragen.

Einen Beitrag zur Erfüllung mindestens einer der erfindungsgemäßen Aufgaben leistet eine Ausführungsform 1 einer Lichtquelle 1, beinhaltend als einander in dieser Reihenfolge überlagernde Bauteile
a) mindestens ein erstes lichtemittierendes Halbleiterbauelement;
b) ein erstes Trägerelement, beinhaltend
   i) eine dem mindestens einen ersten lichtemittierenden Halbleiterbauelement zugewandte erste Trägeroberfläche, und
   ii) zusätzlich eine erste Kühloberfläche; und
c) ein Verteilerelement, beinhaltend
   i) einen ersten Hohlraum, und
   ii) einen weiteren Hohlraum;
wobei der erste Hohlraum und der weitere Hohlraum fluidleitend mittels eines ersten Fluidwegs miteinander verbunden sind; wobei der erste Fluidweg mindestens teilweise durch die erste Kühloberfläche begrenzt wird; wobei die erste Trägeroberfläche und die erste Kühloberfläche einander gegenüberliegende äußere Oberflächen des ersten Trägerelements sind; wobei das Verteilerelement in einer longitudinalen Richtung längserstreckt ist; wobei der erste Hohlraum
a] einen ersten Kanal beinhaltet, der sich in der longitudinalen Richtung längserstreckt, und
b] zusätzlich einen zweiten Kanal, der sich von dem ersten Kanal in Richtung des ersten Trägerelements längserstreckt,
wobei der erste Kanal und der zweite Kanal des ersten Hohlraums fluidleitend miteinander verbunden sind, wobei ein Durchmesser des ersten Kanals des ersten Hohlraums mehr ist als ein Durchmesser des zweiten Kanals des ersten Hohlraums; wobei der weitere Hohlraum
a} einen ersten Kanal beinhaltet, der sich in der longitudinalen Richtung längserstreckt, und
b} zusätzlich einen zweiten Kanal, der sich von dem ersten Kanal in Richtung des ersten Trägerelements längserstreckt,
wobei der erste Kanal und der zweite Kanal des weiteren Hohlraums fluidleitend miteinander verbunden sind, wobei ein Durchmesser des ersten Kanals des weiteren Hohlraums mehr ist als ein Durchmesser des zweiten Kanals des weiteren Hohlraums. Der erste Fluidweg ist gerade der Fluidweg, welcher den ersten Hohlraum unmittelbar mit dem weiteren Hohlraum fluidleitend verbindet. Hierbei beinhaltet der erste Fluidweg nicht ausschließlich die kürzeste Verbindung des ersten Hohlraums mit dem weiteren Hohlraum, sondern alle Wege, die gleichgerichtet hierzu sind, also von dem ersten Hohlraum aus nicht von dem weiteren Hohlraum weg führen. Hier wird der erste Fluidweg insofern mindestens teilweise durch die erste Kühloberfläche begrenzt, als dass mindestens ein Teil des ersten Fluidwegs durch mindestens einen Teil der ersten Kühloberfläche begrenzt wird. Demnach kann die erste Kühloberfläche auch einen oder mehrere Teile beinhalten, die nicht den ersten Fluidweg begrenzen.

In einer erfindungsgemäßen Ausführungsform 2 ist die Lichtquelle 1 nach ihrer Ausführungsform 1 ausgestaltet, wobei das erste Trägerelement lösbar, bevorzugt mittels mindestens eines Befestigungsmittels, mit dem Verteilerelement verbunden ist. Eine lösbare Verbindung besteht zwischen 2 Elementen dann, wenn eines der beiden Elemente mittelbar oder unmittelbar fest, vorzugsweise starr, mit dem anderen der beiden Elemente verbunden ist und diese Verbindung ohne eines der beiden Elemente und im Fall der mittelbaren Verbindung bevorzugt auch ohne ein dazwischenliegendes Element zu beschädigen oder zu zerstören gelöst werden kann. Ein bevorzugtes Befestigungsmittel ist hierbei eine Schraube.

In einer erfindungsgemäßen Ausführungsform 3 ist die Lichtquelle 1 nach ihrer Ausführungsform 1 oder 2 ausgestaltet, wobei die Kühloberfläche mindestens teilweise eine Oberfläche einer Kühlstruktur des ersten Trägerelements ist.

In einer erfindungsgemäßen Ausführungsform 4 ist die Lichtquelle 1 nach ihrer Ausführungsform 3 ausgestaltet, wobei die Kühlstruktur eine Vielzahl von Kühlrippen beinhaltet, bevorzugt daraus gebildet ist.

In einer erfindungsgemäßen Ausführungsform 5 ist die Lichtquelle 1 nach ihrer Ausführungsform 4 ausgestaltet, wobei zumindest ein Teil der Kühlrippen der Vielzahl von Kühlrippen mit dem Verteilerelement kontaktiert ist. Bevorzugt ist jede der Kühlrippen der Vielzahl von Kühlrippen mit dem Verteilerelement kontaktiert.

In einer erfindungsgemäßen Ausführungsform 6 ist die Lichtquelle 1 nach ihrer Ausführungsform 4 oder 5 ausgestaltet, wobei die Vielzahl von Kühlrippen aus 3 bis 30 Kühlrippen, bevorzugt aus 5 bis 25 Kühlrippen, bevorzugter aus 10 bis 20 Kühlrippen besteht.

In einer erfindungsgemäßen Ausführungsform 7 ist die Lichtquelle 1 nach einer ihrer Ausführungsformen 4 bis 6 ausgestaltet, wobei zumindest ein Teil der Kühlrippen der Vielzahl von Kühlrippen entlang des ersten Fluidwegs längserstreckt ist. Bevorzugt sind die Kühlrippen der Vielzahl von Kühlrippen entlang des ersten Fluidwegs längserstreckt. Bevorzugt sind die Kühlrippen der Vielzahl von Kühlrippen planparallel zueinander.

In einer erfindungsgemäßen Ausführungsform 8 ist die Lichtquelle 1 nach einer ihrer Ausführungsformen 4 bis 7 ausgestaltet, wobei die Kühlrippen der Vielzahl von Kühlrippen jeweils eine Dicke in einem Bereich von 0,2 bis 2 mm, bevorzugt von 0,3 bis 1,5 mm, bevorzugter von 0,4 bis 1,2 mm, am bevorzugtesten von 0,5 bis 1,0 mm, haben.

In einer erfindungsgemäßen Ausführungsform 9 ist die Lichtquelle 1 nach einer ihrer Ausführungsformen 4 bis 8 ausgestaltet, wobei jeweils zwei benachbarte Kühlrippen der Vielzahl von Kühlrippen einen Abstand in einem Bereich von 0,2 bis 2 mm, bevorzugt von 0,3 bis 1,5 mm, bevorzugter von 0,5 bis 1,2 mm haben.

In einer erfindungsgemäßen Ausführungsform 10 ist die Lichtquelle 1 nach einer ihrer Ausführungsformen 4 bis 9 ausgestaltet, wobei der erste Fluidweg eine Vielzahl von zwischen jeweils zwei benachbarten Kühlrippen der Vielzahl von Kühlrippen hindurchführenden Kanälen beinhaltet. Diese Kanäle haben bevorzugt jeweils eine Breite, die gleich dem Abstand zwischen zwei benachbarten Kühlrippen ist. Die Vielzahl von zwischen jeweils zwei benachbarten Kühlrippen der Vielzahl von Kühlrippen hindurchführenden Kanälen besteht bevorzugt aus 4 bis 31, bevorzugter 6 bis 26, am bevorzugtesten 11 bis 21, Kanälen. Die Kanäle der Vielzahl von zwischen jeweils zwei benachbarten Kühlrippen der Vielzahl von Kühlrippen hindurchführenden Kanäle sind bevorzugt in einer zu der longitudinalen Richtung senkrechten transversalen Richtung längserstreckt. Bevorzugt verlaufen die Kanäle der Vielzahl von zwischen jeweils zwei benachbarten Kühlrippen der Vielzahl von Kühlrippen hindurchführenden Kanäle parallel zueinander. Die zwischen jeweils zwei benachbarten Kühlrippen der Vielzahl von Kühlrippen hindurchführenden Kanälen haben bevorzugt eine Tiefe, die mindestens 3 mal so groß ist, bevorzugter mindestens 4 mal so groß, am bevorzugtesten mindestens 5 mal so groß, wie ihre Breite.

In einer erfindungsgemäßen Ausführungsform 11 ist die Lichtquelle 1 nach einer ihrer Ausführungsformen 4 bis 10 ausgestaltet, wobei die Kühlrippen der Vielzahl von Kühlrippen jeweils einen ersten Abschnitt und mindestens einen weiteren Abschnitt beinhalten, wobei die ersten Abschnitte der Kühlrippen sich in dem ersten Fluidweg befinden, wobei die weiteren Abschnitte der Kühlrippen sich nicht in dem ersten Fluidweg befinden. Die weiteren Abschnitte tragen hier vorzugweise zu einer möglichst guten Verteilung eines Kühlfluids bei, welche eine möglichst homogene Kühlung des ersten Trägerelements ermöglicht. Hierbei kann sich zwischen dem ersten Abschnitt und dem mindestens einen weiteren Abschnitt einer Kühlrippe eine Unterbrechung der Kühlrippe oder ein Bereich einer geringeren Höhe der Kühlrippe befinden. Bevorzugt sind der erste Abschnitt einer Kühlrippe und der mindestens eine weitere Abschnitt derselben Kühlrippe in einer Richtung, die senkrecht zu einer Höhe der Kühlrippe und senkrecht zu einer Dicke der Kühlrippe ist, nebeneinander angeordnet. Die vorstehende Richtung ist vorzugsweise eine Richtung einer Längserstreckung der Kühlrippe. Besonders bevorzugt beinhalten die Kühlrippen der Vielzahl von Kühlrippen jeweils einen ersten Abschnitt und mindestens 2, noch bevorzugter genau 2, weitere Abschnitte. Hier folgen in der zu der Höhe und der Dicke einer Kühlrippe senkrechten Richtung vorzugsweise ein weiterer Abschnitt dieser Kühlrippe, der erste Abschnitt und ein weiterer Abschnitt der Kühlrippe aufeinander. Bevorzugt verläuft der erste Fluidweg abschnittsweise zwischen jeweils einem weiteren Abschnitt einer Kühlrippe und deren erstem Abschnitt.

In einer erfindungsgemäßen Ausführungsform 12 ist die Lichtquelle 1 nach ihrer Ausführungsform 11 ausgestaltet, wobei die Kühlrippen in ihrem mindestens einen weiteren Abschnitt eine in einer zu den Dicken und Höhen der Kühlrippen senkrechten Richtung, die von den ersten Abschnitten weggerichtet ist, eine abnehmende Höhe haben.

In einer erfindungsgemäßen Ausführungsform 13 ist die Lichtquelle 1 nach einer ihrer Ausführungsformen 3 bis 12 ausgestaltet, wobei der erste Fluidweg in Richtung von dem ersten Hohlraum zu dem weiteren Hohlraum nach dem ersten Hohlraum und vor mindestens einem Teil der Kühlstruktur, bevorzugt vor der Kühlstruktur, einen Verteilerraum beinhaltet, wobei der Verteilerraum dazu angeordnet und ausgebildet ist, ein entlang des ersten Fluidwegs strömendes Kühlfluid auf die Kühlstruktur zu verteilen. Hierzu verbindet der Verteilerraum in Richtung von dem ersten Hohlraum zu dem weiteren Hohlraum den ersten Hohlraum vorzugsweise fluidleitend mit einer Vielzahl von Eingängen der Kühlstruktur. Beinhaltet die Kühlstruktur die Vielzahl von Kühlrippen, so verbindet der Verteilerraum bevorzugt den ersten Hohlraum fluidleitend mit den zwischen jeweils zwei benachbarten Kühlrippen der Vielzahl von Kühlrippen hindurchführenden Kanälen.

In einer erfindungsgemäßen Ausführungsform 14 ist die Lichtquelle 1 nach einer ihrer Ausführungsformen 3 bis 13 ausgestaltet, wobei der erste Fluidweg in Richtung von dem ersten Hohlraum zu dem weiteren Hohlraum nach mindestens einem Teil der Kühlstruktur, bevorzugt nach der Kühlstruktur, und vor dem weiteren Hohlraum einen Sammelraum beinhaltet, wobei der Sammelraum dazu angeordnet und ausgebildet ist, ein entlang des ersten Fluidwegs durch mindestens einen Teil der Kühlstruktur geströmtes Kühlfluid in den weiteren Hohlraum zu leiten. Hierzu verbindet der Sammelraum in Richtung von dem ersten Hohlraum zu dem weiteren Hohlraum bevorzugt eine Vielzahl von Ausgängen der Kühlstruktur fluidleitend mit dem weiteren Hohlraum. Beinhaltet die Kühlstruktur die Vielzahl von Kühlrippen, so verbindet der Sammelraum bevorzugt die zwischen jeweils zwei benachbarten Kühlrippen der Vielzahl von Kühlrippen hindurchführenden Kanäle fluidleitend mit dem weiteren Hohlraum. Bevorzugt besteht der erste Fluidweg in Richtung von dem ersten Hohlraum zu dem weiteren Hohlraum aus dem Verteilerraum, den zwischen jeweils zwei benachbarten Kühlrippen der Vielzahl von Kühlrippen hindurchführenden Kanälen und dem Sammelraum. Zusätzlich können auch Kanäle, die zwischen äußersten Kühlrippen der Vielzahl von Kühlrippen und einem Rand des ersten Trägerelements hindurch führen zu dem ersten Fluidweg gehören.

In einer erfindungsgemäßen Ausführungsform 15 ist die Lichtquelle 1 nach einer ihrer Ausführungsformen 3 bis 14 ausgestaltet, wobei sich die Kühlstruktur mindestens teilweise in dem ersten Fluidweg befindet.

In einer erfindungsgemäßen Ausführungsform 16 ist die Lichtquelle 1 nach einer ihrer vorhergehenden Ausführungsformen ausgestaltet, wobei der erste Fluidweg zusätzlich mindestens teilweise durch eine dem ersten Trägerelement zugewandte Oberfläche des Verteilerelements begrenzt wird. Bevorzugt wird der erste Fluidweg über seine gesamte Erstreckung zwischen dem ersten Hohlraum und dem weiteren Hohlraum durch die Kühloberfläche und bevorzugt zusätzlich durch die dem ersten Trägerelement zugewandte Oberfläche des Verteilerelements begrenzt, vorzugsweise gebildet.

In einer erfindungsgemäßen Ausführungsform 17 ist die Lichtquelle 1 nach einer ihrer vorhergehenden Ausführungsformen ausgestaltet, wobei das erste Trägerelement entlang des ersten Fluidwegs eine minimale Dicke in einem Bereich von 0,5 bis 5 mm, bevorzugt von 0,5 bis 3 mm, bevorzugter von 0,5 bis 2 mm, bevorzugter von 0,5 bis 1,5 mm, am bevorzugtesten von 0,7 bis 1,3 mm, hat.

In einer erfindungsgemäßen Ausführungsform 18 ist die Lichtquelle 1 nach einer ihrer vorhergehenden Ausführungsformen ausgestaltet, wobei jedes erste lichtemittierende Halbleiterbauelement ein Substrat und mindestens einen das Substrat auf einer von dem ersten Trägerelement abgewandten Seite überlagernden Halbleiterchip beinhaltet. Bevorzugt beinhaltet jedes erste lichtemittierende Halbleiterbauelement zusätzlich mindestens eine den mindesten einen Halbleiterchip auf einer von dem Substrat abgewandten Seite überlagernde Optik. Im Fall einer LED als lichtemittierendes Halbleiterbauelement wird der vorstehende Aufbau, beinhaltend das Substrat und den Halbleiterchip und, optional, eine oder mehrere Optiken, im technischen Gebiet auch als *Package* bezeichnet. *Package* und LED werden oft synonym verwendet. Im Fall der im Rahmen der Erfindung ebenfalls in Frage kommenden Chip-on-Board-Technologie sind mehrere Halbleiterchips auf einem gemeinsamen Substrat angeordnet. In diesen Fall beinhaltet das *Package* also mehrere Halbleiterchips. Allgemein kann ein *Package* weitere Elemente wie elektrische Kontakte, Schutzschaltungen und Elemente zur Wärmeabfuhr beinalten.

In einer erfindungsgemäßen Ausführungsform 19 ist die Lichtquelle 1 nach einer ihrer vorhergehenden Ausführungsformen ausgestaltet, wobei das mindestens eine erste lichtemittierende Halbleiterbauelement mindestens eine erste Leuchtdiode ist. Eine bevorzugte erste Leuchtdiode ist eines der oben beschriebenen Packages.

In einer erfindungsgemäßen Ausführungsform 20 ist die Lichtquelle 1 nach einer ihrer vorhergehenden Ausführungsformen ausgestaltet, wobei der erste Hohlraum als ein Zulauf für ein Kühlmedium angeordnet und ausgebildet ist, wobei der weitere Hohlraum als ein Rücklauf für das Kühlmedium angeordnet und ausgebildet ist.

In einer erfindungsgemäßen Ausführungsform 21 ist die Lichtquelle 1 nach einer ihrer vorhergehenden Ausführungsformen ausgestaltet, wobei das mindestens eine erste lichtemittierende Halbleiterbauelement mit der Trägeroberfläche verbunden ist. Bevorzugt ist das mindestens eine erste lichtemittierende Halbleiterbauelement eines ausgewählt aus der Gruppe, bestehend aus auf die Trägeroberfläche geklebt, auf die Trägeroberfläche gelötet, und mit der Trägeroberfläche versintert, oder eine Kombination aus mindestens zwei davon. Vorzugsweise ist das Substrat des mindestens einen ersten lichtemittierenden Halbleiterbauelements mit der Trägeroberfläche verbunden, vorzugsweise auf eine der vorgenannten Arten.

In einer erfindungsgemäßen Ausführungsform 22 ist die Lichtquelle 1 nach einer ihrer vorhergehenden Ausführungsformen ausgestaltet, wobei die Lichtquelle mindestens ein weiteres Trägerelement beinhaltet, wobei jedes weitere Trägerelement
a. das Verteilerelement überlagert,
b. eine weitere Trägeroberflächen hat,
c. zusätzlich eine weitere Kühloberfläche hat, und
d. auf seiner Trägeroberfläche von mindestens einem weiteren lichtemittierenden Halbleiterbauelement überlagert ist,
wobei der erste Hohlraum und der weitere Hohlraum je weiteren Trägerelements mittels eines weitern Fluidwegs fluidleitend miteinander verbunden sind, wobei der jeweilige weitere Fluidweg mindestens teilweise durch die weitere Kühloberfläche des jeweiligen weiteren Trägerelements begrenzt wird.

In einer erfindungsgemäßen Ausführungsform 23 ist die Lichtquelle 1 nach ihrer Ausführungsform 22 ausgestaltet, wobei die Lichtquelle 5 bis 150, bevorzugt 10 bis 150, bevorzugter 15 bis 120, bevorzugter von 15 bis 100, am bevorzugtesten 15 bis 75, weitere Trägerelemente beinhaltet. Besonders bevorzugt ist die Summe aus erstem Trägerelement und weiteren Trägerelementen der Lichtquelle ein ganzzahliges Vielfaches von 2. Dies erleichtert insbesondere eine Ansteuerung einer Kühlung der Lichtquelle.

In einer erfindungsgemäßen Ausführungsform 24 ist die Lichtquelle 1 nach ihrer Ausführungsform 22 oder 23 ausgestaltet, wobei jedes weitere Trägerelement lösbar, bevorzugt mittels jeweils mindestens eines Befestigungsmittels, mit dem Verteilerelement verbunden ist.

In einer erfindungsgemäßen Ausführungsform 25 ist die Lichtquelle 1 nach einer ihrer vorhergehenden Ausführungsformen ausgestaltet, wobei das erste Trägerelement eine Breite in einem Bereich von 5 bis 100 mm, bevorzugt von 10 bis 50 mm, bevorzugter von 15 bis 40 mm, noch bevorzugter von 20 bis 35 mm, am bevorzugtesten von 20 bis 30 mm. Vorzugsweise hat auch jedes weitere Trägerelement die vorstehende Breite in einem Bereich von 5 bis 100 mm, bevorzugt von 10 bis 50 mm, bevorzugter von 15 bis 40 mm, noch bevorzugter von 20 bis 35 mm, am bevorzugtesten von 20 bis 30 mm. Oftmals sind die Trägerelemente etwa einen Zoll, also etwa 25,4 mm, breit. Die Breite eines Trägerelements ist mehr als dessen Dicke und weniger als dessen Länge. Vorzugsweise verläuft die Breite eines Trägerelements in der Lichtquelle in der longitudinalen Richtung.

In einer erfindungsgemäßen Ausführungsform 26 ist die Lichtquelle 1 nach einer ihrer Ausführungsformen 22 bis 25 ausgestaltet, wobei das mindestens eine weitere lichtemittierende Halbleiterbauelement mindestens eine weitere Leuchtdiode ist.

In einer erfindungsgemäßen Ausführungsform 27 ist die Lichtquelle 1 nach einer ihrer vorhergehenden Ausführungsformen ausgestaltet, wobei das Verteilerelement in der longitudinalen Richtung eine Länge in einem Bereich von 100 bis 3000 mm, bevorzugter von 200 bis 3000 mm, bevorzugter von 300 bis 3000 mm, noch bevorzugter von 400 bis 3000 mm, am bevorzugtesten von 400 bis 2000 mm, hat.

In einer erfindungsgemäßen Ausführungsform 28 ist die Lichtquelle 1 nach ihrer Ausführungsform 27 ausgestaltet, wobei das erste Trägerelement und das mindestens eine weitere Trägerelement in der longitudinalen Richtung nacheinander angeordnet sind.

In einer erfindungsgemäßen Ausführungsform 29 ist die Lichtquelle 1 nach einer ihrer vorhergehenden Ausführungsformen ausgestaltet, wobei der erste Hohlraum zwei zweite Kanäle, die sich jeweils von dem ersten Kanal in Richtung des ersten Trägerelements längserstrecken, beinhaltet. Bevorzugt verlaufen die zweiten Kanäle des ersten Hohlraums in dieselbe Richtung, vorzugsweise parallel zueinander. Bevorzugt hat jeder zweite Kanal des ersten Hohlraums einen Durchmesser in einem Bereich von 0,5 bis 5 mm, bevorzugter von 0,7 bis 3 mm, bevorzugter von 0,8 bis 2 mm, noch bevorzugter von 1 bis 1,8 mm, am bevorzugtesten von 1,1 bis 1,5 mm.

In einer erfindungsgemäßen Ausführungsform 30 ist die Lichtquelle 1 nach ihrer Ausführungsform 29 ausgestaltet, wobei keine Querschnittsfläche des ersten Kanals des ersten Hohlraums weniger ist als eine Summe aus jeweils einer Querschnittsfläche jedes zweiten Kanals des ersten Hohlraums.

In einer erfindungsgemäßen Ausführungsform 31 ist die Lichtquelle 1 nach einer ihrer vorhergehenden Ausführungsformen ausgestaltet, wobei der weitere Hohlraum zwei zweite Kanäle, die sich jeweils von dem ersten Kanal in Richtung des ersten Trägerelements längserstrecken, beinhaltet. Bevorzugt verlaufen die zweiten Kanäle des weiteren Hohlraums in dieselbe Richtung, vorzugsweise parallel zueinander. Ferner bevorzugt verlaufen die zweiten Kanäle des ersten und des weiteren Hohlraums in dieselbe Richtung, vorzugsweise parallel zueinander. Bevorzugt hat jeder zweite Kanal des weiteren Hohlraums einen Durchmesser in einem Bereich von 0,5 bis 5 mm, bevorzugter von 0,7 bis 3 mm, bevorzugter von 0,8 bis 2 mm, noch bevorzugter von 1 bis 1,8 mm, am bevorzugtesten von 1,1 bis 1,5 mm.

In einer erfindungsgemäßen Ausführungsform 32 ist die Lichtquelle 1 nach ihrer Ausführungsform 31 ausgestaltet, wobei keine Querschnittsfläche des ersten Kanals des weiteren Hohlraums weniger ist als eine Summe aus jeweils einer Querschnittsfläche jedes zweiten Kanals des weiteren Hohlraums.

In einer erfindungsgemäßen Ausführungsform 33 ist die Lichtquelle 1 nach einer ihrer vorhergehenden Ausführungsformen ausgestaltet, wobei das Verteilerelement in der longitudinalen Richtung durch eine erste Stirnfläche und einer der ersten Stirnfläche sich gegenüberliegende weitere Stirnfläche begrenzt ist, wobei der erste Hohlraum oder der weitere Hohlraum oder beide jeweils sich von der ersten Stirnfläche bis zu der weiteren Stirnfläche längserstreckt.

In einer erfindungsgemäßen Ausführungsform 34 ist die Lichtquelle 1 nach einer ihrer vorhergehenden Ausführungsformen ausgestaltet, wobei der erste Hohlraum zusätzlich für jedes weitere Trägerelement je mindestens einen dritten Kanal beinhaltet, der sich von dem ersten Kanal des ersten Hohlraums in Richtung des jeweiligen weiteren Trägerelements längserstreckt, wobei der erste Kanal und jeder dritte Kanal des ersten Hohlraums fluidleitend miteinander verbunden sind, wobei der Durchmesser des ersten Kanals des ersten Hohlraums mehr ist als ein Durchmesser jedes dritten Kanals des ersten Hohlraums. Bevorzugt beinhaltet der erste Hohlraum zusätzlich für jedes weitere Trägerelement zwei dritte Kanäle, die sich jeweils von dem ersten Kanal des ersten Hohlraums in Richtung des jeweiligen weiteren Trägerelements längserstrecken. Bevorzugt verlaufen die dritten Kanäle des ersten Hohlraums in dieselbe Richtung, vorzugsweise parallel zueinander.

In einer erfindungsgemäßen Ausführungsform 35 ist die Lichtquelle 1 nach einer ihrer vorhergehenden Ausführungsformen ausgestaltet, wobei der weitere Hohlraum zusätzlich für jedes weitere Trägerelement je mindestens einen dritten Kanal beinhaltet, der sich von dem ersten Kanal des weiteren Hohlraums in Richtung des jeweiligen weiteren Trägerelements längserstreckt, wobei der erste Kanal und jeder dritte Kanal des weiteren Hohlraums fluidleitend miteinander verbunden sind, wobei der Durchmesser des ersten Kanals des weiteren Hohlraums mehr ist als ein Durchmesser jedes dritten Kanals des weiteren Hohlraums. Bevorzugt beinhaltet der weitere Hohlraum zusätzlich für jedes weitere Trägerelement zwei dritte Kanäle, die sich jeweils von dem ersten Kanal des weiteren Hohlraums in Richtung des jeweiligen weiteren Trägerelements längserstrecken. Bevorzugt verlaufen die dritten Kanäle des weiteren Hohlraums in dieselbe Richtung, vorzugsweise parallel zueinander. Ferner bevorzugt verlaufen die dritten Kanäle des ersten und des weiteren Hohlraums in dieselbe Richtung, vorzugsweise parallel zueinander.

In einer erfindungsgemäßen Ausführungsform 36 ist die Lichtquelle 1 nach einer ihrer vorhergehenden Ausführungsformen ausgestaltet, wobei das Verteilerelement einstückig ausgebildet ist. Ein Element ist einstückig ausgebildet, wenn es in einem Stück, vorzugsweise aus einem formlosen Stoff, gefertigt wurde, ohne nachträgliches Fügen verschiedener Bestandteile. Demnach beinhaltet das Verteilerelement vorzugsweise keine Fügestelle, wie beispielsweise eine Naht, Schweißstelle, Lötstelle oder Klebestelle. Das Verteilerelement ist bevorzugt einstückig durch ein Strangpressen und optionale nachgelagerte subtraktive Bearbeitungsschritte, wie beispielsweise Bohren, erhältlich.

In einer erfindungsgemäßen Ausführungsform 37 ist die Lichtquelle 1 nach einer ihrer vorhergehenden Ausführungsformen ausgestaltet, wobei das Verteilerelement als ein Gehäuse der Lichtquelle ausgebildet ist. Hierbei ist ein Gehäuse eine Komponente der Lichtquelle, die die übrigen Komponenten der Lichtquelle aufnimmt und im Wesentlichen, das heißt abgesehen von etwaigen Fenstern, Öffnungen und Anschlüssen, eine Außenoberfläche der Lichtquelle bildet, die innenliegende Komponenten vor Umgebungseinflüssen wie Staub und mechanischen Einflüssen, schützt.

In einer erfindungsgemäßen Ausführungsform 38 ist die Lichtquelle 1 nach einer ihrer vorhergehenden Ausführungsformen ausgestaltet, wobei das Verteilerelement keine innere Kühlstruktur hat. Insbesondere weist das Verteilerelement in seinem Inneren keine makroskopischen oder mikroskopischen Kanäle auf, die einer Vergrößerung einer inneren Oberfläche des Verteilerelements zu einer Wärmeabgabe an ein Kühlfluid dienen. Hierbei dienen der erste Hohlraum und der weitere Hohlraum nicht zu der vorgenannten Oberflächenvergrößerung, sondern als gerichteter Zulauf und Rücklauf für ein Kühlfluid. Dies ist insbesondere an einem Fehlen mehrfacher Verzweigungen von Kanälen, die für einen Zulauf oder Rücklauf nicht zielführende Umwege darstellen, erkennbar. Darüber hinaus bevorzugt weist das Verteilerelement alternativ oder zusätzlich auf keiner äußeren Oberfläche eine Kühlstruktur auf.

In einer erfindungsgemäßen Ausführungsform 39 ist die Lichtquelle 1 nach einer ihrer vorhergehenden Ausführungsformen ausgestaltet, wobei das Verteilerelement ein elektrisch leitfähiges Material beinhaltet, bevorzugt daraus besteht. Ein bevorzugtes elektrisch leitfähiges Material ist ein Metall. Ein bevorzugtes Metall ist eines, ausgewählt aus der Gruppe, bestehend aus Aluminium, Kupfer, Gold, Nickel und Stahl, oder eine Kombination aus mindestens zwei davon. Bevorzugt besteht das Verteilerelement aus Aluminium.

In einer erfindungsgemäßen Ausführungsform 40 ist die Lichtquelle 1 nach einer ihrer vorhergehenden Ausführungsformen ausgestaltet, wobei das erste Trägerelement ein elektrisch leitfähiges Material beinhaltet, bevorzugt daraus besteht.

In einer erfindungsgemäßen Ausführungsform 41 ist die Lichtquelle 1 nach einer ihrer vorhergehenden Ausführungsformen ausgestaltet, wobei das erste Trägerelement in Richtung von der Trägeroberfläche zu der Kühloberfläche als einander überlagernde Schichten einer Schichtfolge
I) eine erste Beschichtung, und
II) einen Grundkörper
beinhaltet, wobei die erste Beschichtung die Trägeroberfläche mindestens teilweise, bevorzugt vollständig, bildet.

In einer erfindungsgemäßen Ausführungsform 42 ist die Lichtquelle 1 nach ihrer Ausführungsform 41 ausgestaltet, wobei die erste Beschichtung Gold beinhaltet, bevorzugt daraus besteht.

In einer erfindungsgemäßen Ausführungsform 43 ist die Lichtquelle 1 nach ihrer Ausführungsform 41 oder 42 ausgestaltet, wobei die erste Beschichtung eine Dicke in einem Bereich von 0,01 bis 1 µm, bevorzugter von 0,01 bis 0,5 µm, bevorzugter von 0,01 bis 0,3 µm, am bevorzugtesten von 0,02 bis 0,2 µm, hat.

In einer erfindungsgemäßen Ausführungsform 44 ist die Lichtquelle 1 nach einer ihrer Ausführungsformen 41 bis 43 ausgestaltet, wobei der Grundkörper eines ausgewählt aus der Gruppe, bestehend aus Aluminium, Kupfer, und Stahl, oder eine Kombination aus mindestens zwei davon beinhaltet, bevorzugt daraus besteht, wobei Kupfer besonders bevorzugt ist.

In einer erfindungsgemäßen Ausführungsform 45 ist die Lichtquelle 1 nach einer ihrer Ausführungsformen 41 bis 44 ausgestaltet, wobei das erste Trägerelement zwischen der ersten Beschichtung und dem Grundkörper eine zweite Beschichtung beinhaltet.

In einer erfindungsgemäßen Ausführungsform 46 ist die Lichtquelle 1 nach ihrer Ausführungsform 45 ausgestaltet, wobei die zweite Beschichtung Nickel beinhaltet, bevorzugt daraus besteht.

In einer erfindungsgemäßen Ausführungsform 47 ist die Lichtquelle 1 nach ihrer Ausführungsform 45 oder 46 ausgestaltet, wobei die weitere Beschichtung eine Dicke in einem Bereich von 1 bis 50 µm, bevorzugter von 1 bis 40 µm, bevorzugter von 1 bis 30 µm, bevorzugter von 1 bis 20 µm, bevorzugter von 1 bis 10 µm, bevorzugter von 2 bis 8 µm, am bevorzugtesten von 3 bis 7 µm, hat.

In einer erfindungsgemäßen Ausführungsform 48 ist die Lichtquelle 1 nach einer ihrer Ausführungsformen 45 bis 47 ausgestaltet, wobei das erste Trägerelement zwischen der ersten Beschichtung und der zweiten Beschichtung eine dritte Beschichtung beinhaltet.

In einer erfindungsgemäßen Ausführungsform 49 ist die Lichtquelle 1 nach ihrer Ausführungsform 48 ausgestaltet, wobei die dritte Beschichtung Palladium beinhaltet, bevorzugt daraus besteht.

In einer erfindungsgemäßen Ausführungsform 50 ist die Lichtquelle 1 nach einer ihrer vorhergehenden Ausführungsformen ausgestaltet, wobei das Verteilerelement ferner eine Halterung beinhaltet, die dazu angeordnet und ausgebildet ist, ein Emissionsfenster zu halten. Hier ist das Verteilerelement vorzugsweise auch als Gehäuse der Lichtquelle ausgebildet.

In einer erfindungsgemäßen Ausführungsform 51 ist die Lichtquelle 1 nach ihrer Ausführungsform 50 ausgestaltet, wobei das Emissionsfenster das mindestens eine erste lichtemittierendes Halbleiterbauelement auf einer von dem ersten Trägerelement abgewandten Seite des mindestens einen ersten lichtemittierenden Halbleiterbauelements überlagert.

In einer erfindungsgemäßen Ausführungsform 52 ist die Lichtquelle 1 nach ihrer Ausführungsform 50 oder 51 ausgestaltet, wobei die Lichtquelle das Emissionsfenster beinhaltet.

In einer erfindungsgemäßen Ausführungsform 53 ist die Lichtquelle 1 nach einer ihrer vorhergehenden Ausführungsformen ausgestaltet, wobei die Lichtquelle zusätzlich ein erstes Dichtelement beinhaltet, wobei das erste Dichtelement zu einem fluiddichten Abdichten des ersten Fluidwegs angeordnet und ausgebildet ist. Bevorzugt ist das erste Dichtelement mindestens teilweise zwischen dem ersten Trägerelement und dem Verteilerelement angeordnet. Ferner bevorzugt kontaktiert das erste Dichtelement das erste Trägerelement und das Verteilerelement. Weiter bevorzugt verbindet das erste Dichtelement das erste Trägerelement und das Verteilerelement fluiddicht. Vorzugsweise ist das erste Dichtelement in einer Nut in dem Verteilerelement aufgenommen. Ein bevorzugtes erstes Dichtelement ist als O-ring ausgebildet, wobei dieser O-Ring vorzugsweise statt einer kreisrunden Form eine rechteckige Form hat.

In einer erfindungsgemäßen Ausführungsform 54 ist die Lichtquelle 1 nach einer ihrer vorhergehenden Ausführungsformen ausgestaltet, wobei das mindestens eine erste lichtemittierendes Halbleiterbauelement angeordnet und ausgebildet ist zu einem Abstrahlen von Licht in einem UV-Wellenlängenbereich oder einem IR-Wellenlängenbereich oder beides. Ein bevorzugter UV-Wellenlängeneberich ist ausgewählt aus der Gruppe, bestehend aus einem UV-A-Wellenlängenbereich, einem UV-B-Wellenlängenbereich, und einem UV-C-Wellenlängenbereich, oder aus einer Kombination aus mindestens zwei davon.

In einer erfindungsgemäßen Ausführungsform 55 ist die Lichtquelle 1 nach einer ihrer vorhergehenden Ausführungsformen ausgestaltet, wobei die Lichtquelle ein LED-Modul beinhaltet, bevorzugt ist.

In einer erfindungsgemäßen Ausführungsform 56 ist die Lichtquelle 1 nach einer ihrer vorhergehenden Ausführungsformen ausgestaltet, wobei die Lichtquelle ein Vorschaltgerät beinhaltet. Ein bevorzugtes Vorschaltgerät ist ein elektronisches Vorschaltgerät. Ein bevorzugtes elektronisches Vorschaltgerät ist ein LED-Treiber.

Einen Beitrag zur Erfüllung mindestens einer der erfindungsgemäßen Aufgaben leistet eine Ausführungsform 1 eines Verfahrens 1 zum Herstellen einer Lichtquelle, das Verfahren beinhaltend als Verfahrensschritte
A} Bereitstellen
   a) mindestens eines ersten lichtemittierenden Halbleiterbauelements,
   b) eines ersten Trägerelements, beinhaltend
      i) eine erste Trägeroberfläche, und
      ii) zusätzlich eine erste Kühloberfläche, und
   c) eines Verteilerelement, beinhaltend
      i) einen ersten Hohlraum, und
      ii) einen weiteren Hohlraum; und
B} Lösbares Verbinden des ersten Trägerelements, bevorzugt mittels mindestens eines Befestigungsmittels, mit dem Verteilerelement, so dass der erste Hohlraum und der weitere Hohlraum fluidleitend mittels eines ersten Fluidwegs miteinander verbunden sind;
wobei das mindestens eine erste lichtemittierende Halbleiterbauelement das erste Trägerelement auf einer Seite der ersten Trägeroberfläche überlagert; wobei der erste Fluidweg mindestens teilweise durch die erste Kühloberfläche begrenzt wird; wobei die erste Trägeroberfläche und die erste Kühloberfläche einander gegenüberliegende äußere Oberflächen des ersten Trägerelements sind; wobei das Verteilerelement in einer longitudinalen Richtung längserstreckt ist; wobei der erste Hohlraum
a] einen ersten Kanal beinhaltet, der sich in der longitudinalen Richtung längserstreckt, und
b] zusätzlich einen zweiten Kanal, der sich von dem ersten Kanal in Richtung des ersten Trägerelements längserstreckt,
wobei der erste Kanal und der zweite Kanal des ersten Hohlraums fluidleitend miteinander verbunden sind, wobei ein Durchmesser des ersten Kanals des ersten Hohlraums mehr ist als ein Durchmesser des zweiten Kanals des ersten Hohlraums; wobei der weitere Hohlraum
a} einen ersten Kanal beinhaltet, der sich in der longitudinalen Richtung längserstreckt, und
b} zusätzlich einen zweiten Kanal, der sich von dem ersten Kanal in Richtung des ersten Trägerelements längserstreckt,
wobei der erste Kanal und der zweite Kanal des weiteren Hohlraums fluidleitend miteinander verbunden sind, wobei ein Durchmesser des ersten Kanals des weiteren Hohlraums mehr ist als ein Durchmesser des zweiten Kanals des weiteren Hohlraums. Das lösbare Verbinden im dem Verfahrensschritt B}, beinhaltet vorzugsweise, bevorzugter ist, ein Verschrauben. Ferner bevorzugt wird in dem Verfahrensschritt B} ein erstes Dichtelement mindestens teilweise zwischen dem ersten Trägerelement und dem Verteilerelement angeordnet. Im Rahmen des Verfahrens 1 verwendete Komponenten und Elemente sind jeweils bevorzugt wie gleiche oder entsprechende Komponenten oder Elemente der erfindungsgemäßen Lichtquellem1 gemäß einer ihrer Ausführungsformen ausgestaltet. Bevorzugt ist das Verfahren 1 ein Verfahren zum Herstellen der erfindungsgemäßen Lichtquelle 1 nach einer ihrer Ausführungsformen.

In einer erfindungsgemäßen Ausführungsform 2 ist das Verfahren 1 nach seiner Ausführungsform 1 ausgestaltet, wobei die erste Kühloberfläche mindestens teilweise eine Oberfläche einer Kühlstruktur des ersten Trägerelements ist, wobei in dem Verfahrensschritt A} das Bereitstellen des ersten Trägerelements ein Erzeugen der Kühlstruktur mittels eines Scheibenfräsers beinhaltet. Bevorzugt beinhaltet das Erzeugen ein Fräsen von Kühlrippen mittels Scheibenfräsers. Der Scheibenfräser beinhaltet bevorzugt eine Vielzahl von scheibenförmigen Fräsblättern. Bevorzugt beinhaltet der Scheibenfräser 4 bis 31, bevorzugter 6 bis 26, am bevorzugtesten 11 bis 21, scheibenförmige Fräsblätter. Besonders bevorzugt beinhaltet der Scheibenfräser für jeden zwischen jeweils zwei benachbarten Kühlrippen einer Vielzahl von Kühlrippen der Kühlstruktur hindurchführenden Kanal ein scheibenförmiges Fräsblatt und bevorzugter zusätzlich noch zwei weitere ein scheibenförmige Fräsblätter.

In einer erfindungsgemäßen Ausführungsform 3 ist das Verfahren 1 nach seiner Ausführungsform 1 oder 2 ausgestaltet, wobei in dem Verfahrensschritt A} ferner mindestens ein weiteres lichtemittierendes Halbleiterbauelement und mindestens ein weiteres Trägerelement bereitgestellt werden, wobei jedes weitere Trägerelement
a. eine weitere Trägeroberflächen hat,
b. zusätzlich eine weitere Kühloberfläche hat, und
c. auf seiner weiteren Trägeroberfläche von mindestens einem weiteren lichtemittierenden Halbleiterbauelement überlagert ist,
wobei das Verfahren weiter einen Verfahrensschritt
C} Lösbares Verbinden des mindestens einen weiteren Trägerelements, bevorzugt jeweils mittels mindestens eines Befestigungsmittels, mit dem Verteilerelement, so dass der erste Hohlraum und der weitere Hohlraum je weiteren Trägerelements mittels eines weiteren Fluidwegs fluidleitend miteinander verbunden sind,
wobei der jeweilige weitere Fluidweg mindestens teilweise durch die weitere Kühloberfläche des jeweiligen weiteren Trägerelements begrenzt wird.

Offenbart wird ferner eine Ausführungsform 1 einer Lichtquelle 2, erhältlich durch das Verfahren 1 nach einer seiner Ausführungsformen. Die Lichtquelle 2 ist vorzugsweise wie die Lichtquelle 1 gemäß einer ihrer Ausführungsformen, besonders bevorzugt gemäß der Ausführungsform 11 oder 12, ausgebildet.

Einen Beitrag zur Erfüllung mindestens einer der erfindungsgemäßen Aufgaben leistet eine Ausführungsform 1 einer Druckmaschine, beinhaltend die Lichtquelle 1 nach einer ihrer vorhergehenden Ausführungsformen. Als erfindungsgemäße Druckmaschine kommt jede Art Druckmaschine in Betracht, die sich zum Einsatz der erfindungsgemäßen Lichtquelle 1 eignet. Eine bevorzugte Druckmaschine ist zu einem Durchführen des erfindungsgemäßen Verfahrens 2 nach einer seiner Ausführungsformen ausgebildet.

In einer erfindungsgemäßen Ausführungsform 2 ist die Druckmaschine nach ihrer Ausführungsform 1 ausgestaltet, wobei die Lichtquelle in der Druckmaschine zu einem Bestrahlen einer auf einen Druckträger gedruckten Zusammensetzung angeordnet und ausgebildet ist.

In einer erfindungsgemäßen Ausführungsform 3 ist die Druckmaschine nach ihrer Ausführungsform 2 ausgestaltet, wobei die Zusammensetzung eine Druckfarbe oder ein Lack oder beides ist.

In einer erfindungsgemäßen Ausführungsform 4 ist die Druckmaschine nach einer ihrer Ausführungsformen 1 bis 3 ausgestaltet, wobei die Druckmaschine eine druckbildspeicherlose Druckmaschine ist. Eine bevorzugte druckbildspeicherlose Druckmaschine ist für ein berührungsloses Drucken (Non Impact Printing - NIP) ausgebildet. Eine bevorzugte druckbildspeicherlose Druckmaschine ist ein Tintenstrahldrucker oder ein Laserdrucker oder beides.

In einer erfindungsgemäßen Ausführungsform 5 ist die Druckmaschine nach einer ihrer Ausführungsformen 1 bis 3 ausgestaltet, wobei die Druckmaschine einen Druckbildspeicher beinhaltet. Ein bevorzugter Druckbildspeicher ist eine Druckwalze oder eine Druckplatte.

In einer erfindungsgemäßen Ausführungsform 6 ist die Druckmaschine nach ihrer Ausführungsform 5 ausgestaltet, wobei die Druckmaschine für ein indirektes Drucken mittels des Druckbildspeichers angeordnet und ausgebildet ist. Eine bevorzugte Druckmaschine für ein indirektes Drucken ist eine Offset-Druckmaschine. Eine bevorzugte Offset-Druckmaschine ist eine Bogen-Offset-Druckmaschine.

Einen Beitrag zur Erfüllung mindestens einer der erfindungsgemäßen Aufgaben leistet eine Ausführungsform 1 eines Verfahrens 2, beinhaltend als Verfahrensschritte
A) Bereitstellen
   I) der Lichtquelle 1 nach einer ihrer Ausführungsformen, und
   II) eines Objekts;
B) Überlagern des Objekts mit einer Zusammensetzung; und
C) Bestrahlen der Zusammensetzung mit von dem mindestens einen ersten lichtemittierenden Halbleiterbauelement abgestrahltem Licht.

In einer erfindungsgemäßen Ausführungsform 2 ist das Verfahren 2 nach seiner Ausführungsform 1 ausgestaltet, wobei die Zusammensetzung in dem Verfahrensschritt B), bevorzugt auch in dem Verfahrensschritt C), flüssig ist.

In einer erfindungsgemäßen Ausführungsform 3 ist das Verfahren 2 nach seiner Ausführungsform 1 oder 2 ausgestaltet, wobei die Zusammensetzung in dem Verfahrensschritt B) mindestens ein Farbmittel, bevorzugt zu einem Anteil in einem Bereich von 0,5 bis 20 Gew.-%, bevorzugter von 1 bis 15 Gew.-%, bevorzugter von 2 bis 10 Gew.-%, am bevorzugtesten von 3 bis 8 Gew.-%, jeweils bezogen auf die Zusammensetzung in dem Verfahrensschritt B), beinhaltet.

In einer erfindungsgemäßen Ausführungsform 4 ist das Verfahren 2 nach einer seiner Ausführungsformen 1 bis 3 ausgestaltet, wobei die Zusammensetzung in dem Verfahrensschritt B) ein Vehikel, bevorzugt zu einem Anteil in einem Bereich von 10 bis 95 Gew.-%, bevorzugter von 20 bis 95 Gew.-%, bevorzugter von 30 bis 95 Gew.-%, am bevorzugtesten von 40 bis 90 Gew.-%, jeweils bezogen auf die Zusammensetzung in dem Verfahrensschritt B), beinhaltet.

In einer erfindungsgemäßen Ausführungsform 5 ist das Verfahren 2 nach einer seiner Ausführungsformen 1 bis 4 ausgestaltet, wobei die Zusammensetzung in dem Verfahrensschritt B) einen Photoinitiator, bevorzugt zu einem Anteil in einem Bereich von 1 bis 30 Gew.-%, bevorzugter von 2 bis 25 Gew.-%, bevorzugter von 3 bis 20 Gew.-%, am bevorzugtesten von 5 bis 15 Gew.-%, jeweils bezogen auf die Zusammensetzung in dem Verfahrensschritt B), beinhaltet.

In einer erfindungsgemäßen Ausführungsform 6 ist das Verfahren 2 nach einer seiner Ausführungsformen 1 bis 5 ausgestaltet, wobei die Zusammensetzung in dem Verfahrensschritt B) mindestens ein Monomer, bevorzugt zu einem Anteil in einem Bereich von 10 bis 95 Gew.-%, bevorzugter von 20 bis 95 Gew.-%, bevorzugter von 30 bis 90 Gew.-%, bevorzugter von 40 bis 85 Gew.-%, bevorzugter von 50 bis 85 Gew.-%, am bevorzugtesten von 60 bis 80 Gew.-%, jeweils bezogen auf die Zusammensetzung in dem Verfahrensschritt B), beinhaltet.

In einer erfindungsgemäßen Ausführungsform 7 ist das Verfahren 2 nach einer seiner Ausführungsformen 1 bis 6 ausgestaltet, wobei die Zusammensetzung in dem Verfahrensschritt B) mindestens ein Oligomer, bevorzugt zu einem Anteil in einem Bereich von 1 bis 50 Gew.-%, bevorzugt von 1 bis 40 Gew.-%, bevorzugter von 2 bis 30 Gew.-%, bevorzugter von 3 bis 25 Gew.-%, am bevorzugtesten von 5 bis 20 Gew.-%, jeweils bezogen auf die Zusammensetzung in dem Verfahrensschritt B), beinhaltet.

In einer erfindungsgemäßen Ausführungsform 8 ist das Verfahren 2 nach einer seiner Ausführungsformen 1 bis 7 ausgestaltet, wobei der Verfahrensschritt C) ein Härten der Zusammensetzung beinhaltet.

In einer erfindungsgemäßen Ausführungsform 9 ist das Verfahren 2 nach seiner Ausführungsform 8 ausgestaltet, wobei das Härten ein Verringern eines Anteils eines Vehikels in der Zusammensetzung beinhaltet.

In einer erfindungsgemäßen Ausführungsform 10 ist das Verfahren 2 nach seiner Ausführungsform 8 oder 9 ausgestaltet, wobei das Härten ein Polymerisieren eines Monomers oder eines Oligomers oder beider in der Zusammensetzung beinhaltet.

In einer erfindungsgemäßen Ausführungsform 11 ist das Verfahren 2 nach einer seiner Ausführungsformen 1 bis 10 ausgestaltet, wobei die Zusammensetzung eine Druckfarbe oder ein Lack oder beides ist.

In einer erfindungsgemäßen Ausführungsform 12 ist das Verfahren 2 nach einer seiner Ausführungsformen 1 bis 11 ausgestaltet, wobei das Verfahren ein Verfahren zum Herstellen eines Druckerzeugnisses ist.

In einer erfindungsgemäßen Ausführungsform 13 ist das Verfahren 2 nach einer seiner Ausführungsformen 1 bis 12 ausgestaltet, wobei in dem Verfahrensschritt A) die erfindungsgemäße Druckmaschine nach einer ihrer Ausführungsformen bereitgestellt wird.

In einer erfindungsgemäßen Ausführungsform 14 ist das Verfahren 2 nach einer seiner Ausführungsformen 1 bis 13 ausgestaltet, wobei das Überlagern in dem Verfahrensschritt B) ein Bedrucken des Objekts mit der Zusammensetzung ist. Ein bevorzugtes Objekt ist hierbei ein Druckträger, auch Bedruckstoff genannt.

In einer erfindungsgemäßen Ausführungsform 15 ist das Verfahren 1 nach einer seiner Ausführungsformen 1 bis 14 ausgestaltet, wobei in dem Verfahrensschritt C) ein Kühlfluid durch den ersten Fluidweg strömt.

In einer erfindungsgemäßen Ausführungsform 16 ist das Verfahren 2 nach seiner Ausführungsform 15 ausgestaltet, wobei in dem Verfahrensschritt C) das Kühlfluid mit einem Druck in einem Bereich von mehr als 1 bis zu 20 bar, bevorzugt von mehr als 1 bis 15 bar, bevorzugter von mehr als 1 bis 10 bar, bevorzugter von mehr als 1 bis 8 bar, bevorzugter von 2 bis 6 bar, am bevorzugtesten von 3 bis 5 bar, durch den ersten Fluidweg strömt.

In einer erfindungsgemäßen Ausführungsform 17 ist das Verfahren 2 nach einer seiner Ausführungsformen 1 bis 16 ausgestaltet, wobei in dem Verfahrensschritt C) das erste Trägerelement mit einer Kühlleistung in einem Bereich von 100 bis 1000 W, bevorzugt 100 bis 500 W, bevorzugter von 200 bis 400 W, gekühlt wird. Beinhaltet die Lichtquelle mindestens ein weiteres Trägerelement, wird bevorzugt jedes weitere Trägerelement mit einer Kühlleistung in einem der vorstehenden Bereiche gekühlt.

In einer erfindungsgemäßen Ausführungsform 18 ist das Verfahren 2 nach einer seiner Ausführungsformen 1 bis 17 ausgestaltet, wobei die Lichtquelle die Lichtquelle 1 nach einer ihrer Ausführungsformen 21 bis 50 ist, wobei in dem Verfahrensschritt C) eine maximale Temperatur der Trägeroberfläche des ersten Trägerelements um nicht mehr als 10 K, bevorzugt nicht mehr als 8 K, bevorzugter nicht mehr als 6, am bevorzugtesten nicht mehr als 5 K, von einer maximalen Temperatur der Trägeroberfläche jedes weiteren Trägerelements abweicht.

Offenbart wird auch eine Ausführungsform 1 eines Druckerzeugnisses, erhältlich durch das Verfahren 2 nach einer seiner Ausführungsformen 1 bis 18.

In einer Ausführungsform 2 ist das Druckerzeugnis nach seiner Ausführungsform 1 ausgestaltet, wobei das Druckerzeugnis eines ausgewählt aus der Gruppe, bestehend aus einer Zeitschrift, einem Buch, einem Plakat, einem Werbemittel, und einem Etikett oder eine Kombination aus mindestens zwei davon ist.

Einen Beitrag zur Erfüllung mindestens einer der erfindungsgemäßen Aufgaben leistet eine Ausführungsform 1 einer Anordnung, beinhaltend
A. die Lichtquelle 1 nach einer ihrer Ausführungsformen, und
B. ein Bestrahlungsgut,
wobei die Lichtquelle und das Bestrahlungsgut zu einem Bestrahlen des Bestrahlungsguts mit von dem mindestens einen ersten lichtemittierenden Halbleiterbauelement abgestrahltem Licht angeordnet und ausgebildet sind.

In einer erfindungsgemäßen Ausführungsform 2 ist die Anordnung nach ihrer Ausführungsform 1 ausgestaltet, wobei das Bestrahlungsgut ein Objekt und eine das Objekt überlagernde Zusammensetzung beinhaltet, wobei die Lichtquelle und das Bestrahlungsgut zu einem Bestrahlen der Zusammensetzung mit dem von dem mindestens einen ersten lichtemittierenden Halbleiterbauelement abgestrahltem Licht angeordnet und ausgebildet sind. Ein bevorzugtes Objekt ist ein Druckträger. Die Zusammensetzung ist bevorzugt gemäß einer Ausführungsform des erfindungsgemäßen Verfahrens 2 ausgestaltet.

Einen Beitrag zur Erfüllung mindestens einer der erfindungsgemäßen Aufgaben leistet eine Ausführungsform 1 eines Verfahrens 3, beinhaltend als Verfahrensschritte
A] Bereitstellen der erfindungsgemäßen Anordnung nach einer ihrer Ausführungsformen; und
B] Bestrahlen des Bestrahlungsguts mit von dem mindestens einen ersten lichtemittierenden Halbleiterbauelement abgestrahltem Licht.

In einer bevorzugten Ausführungsform ist das Verfahren 3 ein Verfahren zu einem Bestrahlen des Bestrahlungsguts.

In einer erfindungsgemäßen Ausführungsform 2 ist das Verfahren 3 nach seiner Ausführungsform 1 ausgestaltet, wobei der Verfahrensschritt B] ein Härten einer Zusammensetzung beinhaltet. Das Verfahren 3 ist bevorzugt ein Verfahren zu einem Härten der Zusammensetzung.

In einer erfindungsgemäßen Ausführungsform 3 ist das Verfahren 3 nach seiner Ausführungsform 2 ausgestaltet, wobei das Härten ein Verringern eines Anteils eines Vehikels in der Zusammensetzung beinhaltet.

In einer erfindungsgemäßen Ausführungsform 4 ist das Verfahren 3 nach seiner Ausführungsform 2 oder 3 ausgestaltet, wobei das Härten ein Polymerisieren eines Monomers oder eines Oligomers oder beider in der Zusammensetzung beinhaltet.

Einen Beitrag zur Erfüllung mindestens einer der erfindungsgemäßen Aufgaben leistet eine Ausführungsform 1 einer Verwendung 1 der Lichtquelle 1 nach einer ihrer Ausführungsformen, zu einem Härten einer Zusammensetzung. Die Zusammensetzung ist bevorzugt gemäß einer Ausführungsform des erfindungsgemäßen Verfahrens 2 ausgestaltet. Ferner erfolgt das Härten bevorzugt gemäß einer Ausführungsform des erfindungsgemäßen Verfahrens 2.

Einen Beitrag zur Erfüllung mindestens einer der erfindungsgemäßen Aufgaben leistet eine Ausführungsform 1 einer Verwendung 2 der Lichtquelle 1 nach einer ihrer Ausführungsformen, in einer Druckmaschine. Eine bevorzugte Druckmaschine ist wie die erfindungsgemäße Druckmaschine nach einer ihrer Ausführungsformen ausgestaltet. Ferner wird die Lichtquelle in der Druckmaschine vorzugsweise zu einem Härten einer Zusammensetzung verwendet. Das Härten erfolgt bevorzugt gemäß einer Ausführungsform des erfindungsgemäßen Verfahrens 2.

Merkmale, die in einer erfindungsgemäßen Kategorie als bevorzugt beschrieben sind, beispielsweise nach der Lichtquelle 1 oder dem Verfahren 1 der Erfindung, sind ebenso in einer Ausführungsform der weiteren erfindungsgemäßen Kategorien, beispielsweise einer Ausführungsform der erfindungsgemäßen Anordnung oder der Verwendung 1 oder 2, bevorzugt.

### Lichtquelle

Als Lichtquelle kommt im Rahmen der Erfindung jede zum Emittieren elektromagnetischer Strahlung ausgebildete Vorrichtung, die dem Fachmann für den erfindungsgemäßen Einsatz, vorzugsweise zum Einsatz in einer Druckmaschine, geeignet erscheint, in Frage. Der Begriff elektromagnetische Strahlung umfasst neben sichtbarem Licht auch für das menschliche Auge nicht sichtbare Bestandteile des elektromagnetischen Spektrums. Bevorzugte elektromagnetische Strahlung liegt im Wellenlängenbereich von 10 nm bis 1 mm. Ferner bevorzugte elektromagnetische Strahlung ist Infrarotstrahlung (IR-Strahlung) oder ultraviolette Strahlung (UV-Strahlung) oder eine Mischung aus beiden. Gemäß der Norm DIN 5031-7 erstreckt sich der Wellenlängenbereich der UV-Strahlung von 10 bis 380 nm. Hierbei liegt UV-A-Strahlung definitionsgemäß im Bereich von 315 bis 380 nm, UV-B-Strahlung im Bereich von 280 bis 315 nm, UV-C-Strahlung im Bereich von 100 bis 280 nm, und EUV-Strahlung im Bereich von 10 bis 121 nm. Im Rahmen der Erfindung ist UV-Strahlung, ausgewählt aus der Gruppe, bestehend aus UV-A-Strahlung, UV-B-Strahlung, und UV-C-Strahlung, oder eine Kombination aus mindestens zwei davon besonderes bevorzugt. Hierbei ist zu berücksichtigen, dass die vorgenannte Norm zwar die Wellenlängenbereiche von UV-Strahlung definiert, im technischen Gebiet der LED, welche wie untenstehend beschrieben im Rahmen der Erfindung bevorzugte lichtemittierende Halbleiterbauelemente sind, jedoch auch LED mit Maxima der abgestrahlten Intensität (im technischen Gebiet auch *Peakwellenlänge* genannt) bei Wellenlängen, die nicht in den in der Norm angegebenen Wellenlängenbereichen liegen, als UV-LED bezeichnet werden. Beispielsweise werden auch LED mit Maxima der abgestrahlten Intensität bei Wellenlängen von 385 nm, 395 nm und 405 nm als UV-A-LED bezeichnet. Im Rahmen der Erfindung gehören auch solche LED zu den bevorzugten lichtemittierenden Halbleiterbauelementen. Ferner wird hier die Bezeichnungsweise des technischen Gebiets übernommen und auch solche LED als UV-LED bezeichnet. Eine bevorzugte Lichtquelle beinhaltet ein LED-Modul oder ist ein LED-Modul. Ein LED-Modul beinhaltet vorzugsweise eine Platine, auf der mehrere LED angeordnet sind. Die LED können hierbei jeweils mit einer Optik ausgestattet sein. Ferner kann eine Optik auch mehreren LED zugeordnet sein. Eine Optik ist hierin ein Element, welches zur Manipulation elektromagnetischer Strahlung angeordnet und ausgebildet ist. In Frage kommen hierbei sowohl optische Bauelemente als auch optische Komponenten. Eine bevorzugte Optik ist eine, ausgewählt aus der Gruppe, bestehend aus einer Transmissionsoptik, einer Konversionsoptik, und einer Reflexionsoptik, oder eine Kombination aus mindestens zwei davon. Eine Transmissionsoptik ist eine Optik, die zur Manipulation der elektromagnetischen Strahlung von dieser durchquert wird. Eine bevorzugte Transmissionsoptik ist eine Linse oder ein Transmissionsgitter. Eine Konversionsoptik ist eine Optik, die zur Veränderung einer Wellenlänge elektromagnetischer Strahlung angeordnet und ausgebildet ist. Diese kann im Fall einer LED vorzugsweise zum Anpassen einer Farbe des von der LED emittierten Lichts dienen. Eine bevorzugte Konversionsoptik ist eine Konversionsschicht, also eine mindestens einen Fluoreszenzfarbstoff beinhaltende Schicht. Eine Reflexionsoptik ist eine Optik, die zur Manipulation der elektromagnetischen Strahlung, insbesondere einer Ausbreitungsrichtung der elektromagnetischen Strahlung, diese reflektiert. Eine bevorzugte Reflexionsoptik ist ein Spiegel oder ein Reflexionsgitter. Die Lichtquelle beinhaltet ferner bevorzugt ein Vorschaltgerät, welches zum Betreiben des LED-Moduls angeordnet und ausgebildet ist. Ein bevorzugtes Vorschaltgerät ist ein LED-Treiber.

### Lichtemittierendes Halbleiterbauelement

Als lichtemittierendes Halbleiterbauelement kommt jedes einen Halbleiter beinhaltende Bauteil in Frage, welches dem Fachmann als lichtemittierendes Bauelemente der erfindungsgemäßen Lichtquelle geeignet erscheint. Zu den lichtemittierenden Halbleiterbauelementen gehören insbesondere Leuchtdioden (LED) und Laserdioden (auch Halbleiterlaser genannt), wobei Leuchtdioden hier besonders bevorzugt sind. Eine besonders bevorzugte LED ist eine IR-LED oder eine UV-LED oder beides. Eine bevorzugte UV-LED ist eine, ausgewählt aus der Gruppe, bestehend aus eine UV-A-LED, einer UV-B-LED, und einer UV-C-LED, oder eine Kombination aus mindestens zwei davon.

### Trägerelement

Als Trägerelement kommt jedes dem Fachmann für den Einsatz in einer erfindungsgemäßen Lichtquelle geeignet erscheinende Bauteil in Frage. Ein bevorzugtes Trägerelement ist plattenförmig, also als Trägerplatte, ausgebildet. Ein besonders bevorzugtes Trägerelement ist eine Kühlplatte. Als Platte wird hierin ein flächenförmig ausgebildetes Element bezeichnet, dessen Dicke an jeder Stelle um mindestens einen Faktor 2, bevorzugter mindestens 5, geringer ist als jeweils dessen Länge und Breite. Das Trägerelement besteht vorzugsweise zu mindestens 80 Gew.-%, bevorzugter zu mindestens 90 Gew.-%, noch bevorzugter zu mindestens 95 Gew.-%, aus einem Material mit einer Wärmeleitfähigkeit von mindestens 50 W/(m·K), bevorzugter mindestens 100 W/(m·K), noch bevorzugter mindestens 200 W/(m·K), am bevorzugtesten mindestens 230 W/(m·K). Bevorzugt beinhaltet das Trägerelement zu mindestens 80 Gew.-%, bevorzugter zu mindestens 90 Gew.-%, noch bevorzugter zu mindestens 95 Gew.-%, ein Metall. Ein bevorzugtes Metall ist Kupfer oder Aluminium oder eine Legierung beinhaltend eines oder beide der vorgenannten Metalle. In einer bevorzugten Ausgestaltung bildet das vorgenannte Material einen Grundkörper des Trägerelements, welcher zudem eine oder mehrere Beschichtungen aufweisen kann. Eine bevorzugte Beschichtung besteht aus einem, ausgewählt aus der Gruppe, bestehend aus Nickel, Palladium, und Gold, oder aus einer Legierung, beinhaltend mindestens eines der vorgenannten Metalle. Beinhaltet das Trägerelement mehrere Beschichtungen, überlagern diese den Grundkörper vom Grundkörper nach außen bevorzugt in der vorgenannten Reihenfolge. Hierbei sind die Schichtfolgen Grundkörper, Nickelbeschichtung, Goldbeschichtung und auch Grundkörper, Nickelbeschichtung, Palladiumbeschichtung, Goldbeschichtung besonders bevorzugt. Das Trägerelement weist die vorgenannten Beschichtungen besonders bevorzugt mindestens auf der Seite seiner Trägeroberfläche auf. Bei den hierin als Trägerelement bezeichneten Elementen handelt es sich bevorzugt nicht um ein Substrat oder eine Platine einer LED oder eines LED-Moduls. Vielmehr ist das Trägerelement vorzugsweise ein Bauteil, auf dessen Trägeroberfläche eine Vielzahl von LED oder ein LED-Modul angeordnet sein können. Die Trägeroberfläche eines Trägerelements ist bevorzugt weitestgehend eben ausgebildet.

### Kühlstruktur

Als Kühlstruktur kommt hie jede Struktur in Frage, die dem Fachmann zur Erhöhung einer Wärmeabgabe des Trägerelements von ihrer Kühloberfläche an eine Umgebung, insbesondere an ein Kühlfluid, geeignet erscheint. Eine bevorzugte Kühlstruktur beinhaltet eines, ausgewählt aus der Gruppe, bestehend aus Lamellen, Kühlrippen, Poren, und Kanälen, oder eine Kombination aus mindestens zwei davon. Hierbei sind Kühlrippen besonders bevorzugt. Kühlrippen werden auch als Kühlfinnen bezeichnet. Kühlrippen sind flächenförmige Elemente. Diese flächenförmigen Elemente sind vorzugsweise jeweils an einer Kante mit einem Trägerelement, zu dem die jeweilige Kühlstruktur gehört, verbunden. Eine gegenüberliegende Kante des flächenförmigen Elements ist in der erfindungsgemäßen Lichtquelle vorzugsweise mit dem Verteilerelement kontaktiert. Die flächenförmigen Elemente sind vorzugsweise planparallel zueinander angeordnet. Ferner weisen die flächenförmigen Elemente vorzugsweise rechteckige Seitenflächen auf.

### Verteilerelement

Als Verteilerelement kommt grundsätzlich jedes Bauteil in Frage, welches dem Fachmann für den erfindungsgemäßen Einsatz geeignet erscheint. Das Verteilerelement dient bevorzugt als Verteiler für ein Kühlfluid und als Bauteil, welches das erste Trägerelement und die etwaigen weiteren Trägerelemente der erfindungsgemäßen Lichtquelle trägt. Hierfür weist das Verteilerelement vorzugsweise elektrische Anschlüsse und auch Anschlüsse für einen Zulauf und einen Rücklauf eines Kühlfluids auf. Die vorgenannten Anschlüsse befinden sich bevorzugt an einer oder beiden Stirnseite des Verteilerelements. Ferner beinhaltet das Verteilerelement vorzugsweis einen Zulauf und einen Rücklauf für ein Kühlfluid.

### Überlagern

Wird hierin definiert, dass ein Element, beispielsweise eine Schicht oder ein Bauteil, ein anderes Element überlagert, so können diese Elemente unmittelbar, das heißt ohne dazwischenliegendes weiteres Element, aufeinanderfolgen oder mittelbar, das heißt mit mindestens einem dazwischenliegenden weiteren Element. Unmittelbar aufeinanderfolgende Elemente grenzen bevorzugt aneinander an, das heißt, dass sie miteinander kontaktiert sind. Ferner sind einander überlagernde Elemente vorzugsweise miteinander verbunden. Einander überlagernde Elemente können mittelbar oder unmittelbar miteinander verbunden sein. Zwei Elemente sind miteinander verbunden, wenn ihre Haftung aneinander über Van-der-Waals-Anziehungskräfte hinausgeht. Miteinander verbundene Elemente sind bevorzugt eines ausgewählt aus der Gruppe bestehend aus miteinander verlötet, verschweißt, versintert, verschraubt, und miteinander verklebt, oder eine Kombination aus mindestens zwei davon. Eine Formulierung, in der eine Schichtfolge aufgezählte Schichten oder Beschichtungen beinhaltet, bedeutet, dass zumindest die angegebenen Schichten oder Beschichtungen in der angegebenen Reihenfolge vorliegen. Diese Formulierung besagt nicht zwingend, dass diese Schichten oder Beschichtungen unmittelbar aufeinander folgen. Eine Formulierung, in der zwei Schichten aneinander angrenzen, besagt, dass diese beiden Schichten unmittelbar und somit ohne Zwischenschicht aufeinanderfolgen. Überlagert in einer Schichtfolge eine Schicht eine andere Schicht, so überlagert die Schicht die andere Schicht nicht zwingend über die gesamte Fläche der einen oder anderen Schicht, jedoch vorzugsweise über einen flächigen Bereich der beiden Schichten. Die die Schichtfolge bildenden Schichten des flächenförmigen Verbunds sind bevorzugt flächig miteinander verbunden.

### Fluidweg

Sind zwei Hohlräume oder Bereiche eines oder mehrerer Hohlräume miteinander fluidleitend verbunden, so können diese unmittelbar miteinander fluidleitend verbunden sein, also aneinander angrenzen, oder mittelbar miteinander fluidleitend verbunden sein, also mit einem Hohlraum oder einem Bereich eines Hohlraums dazwischen. In jedem Fall sind die vorgenannten Bereiche oder Hohlräume so miteinander verbunden, dass ein Fluid von dem einen Bereich oder Hohlraum in den anderen fließen kann. Ein bevorzugtes Fluid ist hierbei ein Kühlfluid.

### Kühlfluid

Als Kühlfluid kommt jedes dem Fachmann im Rahmen der Erfindung, insbesondere zum Kühlen der erfindungsgemäßen Lichtquelle, geeignet erscheinende Fluid in Frage. Ein Fluid ist hierin ein fließfähiges Medium. Hierzu gehören insbesondere Gase und Flüssigkeiten. Als Kühlfluid ist hierin eine Kühlflüssigkeit bevorzugt. Eine bevorzugte Kühlflüssigkeit beinhaltet Wasser oder Glykol oder eine Mischung aus beiden. Bevorzugt besteht die Kühlflüssigkeit aus Wasser oder einem Wasser-Glykol-Gemisch.

### Härten

Das Härten einer Zusammensetzung ist hierin ein Verfestigen der Zusammensetzung, wobei aus der Zusammensetzung eine Schicht erhalten wird, welche bei dem Härten bevorzugt auch mit dem darunterliegenden Objekt verbunden wird. Bei der Schicht kann es sich um eine zusammenhängende Schicht handeln, was im Fall eines Lacks als Zusammensetzung bevorzugt ist, oder um eine nicht zusammenhängende Schicht, beispielsweise in Form von aus einer Druckfarbe gebildeten Buchstaben. Ein bevorzugtes Härten ist ein physikalisches Härten oder ein chemisches Härten oder beides. Ein bevorzugtes physikalisches Härten ist ein Trocknen. Ein Trocknen beinhaltet vorzugsweise ein Verringern eines Anteils eines Vehikels in der Zusammensetzung, vorzugsweise auf 0 Gew.-%, bevorzugt durch Verdampfen des Vehikels. Ein bevorzugtes Vehikel ist ein organisches Vehikel oder ein anorganisches Vehikel. Als anorganisches Vehikel ist Wasser bevorzugt. Ein weiteres bevorzugtes Vehikel ist ein Lösemittel. Ein chemisches Härten beinhaltet eine chemische Reaktion. Eine bevorzugte chemische Reaktion ist eine Polymerisationsreaktion oder eine Vernetzungsreaktion oder beides. Handelt es sich bei der Zusammensetzung um eine pulverförmige Zusammensetzung beinhaltet das Härten ein Verbinden von Partikeln der pulverförmigen Zusammensetzung unter Erhalt eines zusammenhängenden Festkörpers, welcher bevorzugt zudem mit dem darunterliegenden Objekt verbunden ist. Im Fall einer flüssigen Zusammensetzung geht diese bei dem Härten von dem flüssigen Zustand in den festen Zustand über.

### Druckträger

Als Druckträger, auch Bedruckstoff genannt, kommt jedes dem Fachmann im Rahmender Erfindung geeignet erscheinende Objekt in Frage. Ein bevorzugter Druckträger ist flächenförmig ausgebildet. Dies bedeutet, dass eine Länge und eine Breite des Druckträgers um einen Faktor von mindestens 10, bevorzugter mindestens 100, noch bevorzugter mindestens 1000, größer sind als eine Dicke des Druckträgers. Ein bevorzugter flächenförmiger Druckträger ist bahnförmig ausgebildet. Dies bedeutet, dass eine Länge des Druckträgers um einen Faktor von mindestens 2, bevorzugter mindestens 5, noch bevorzugter mindestens 10, am bevorzugtesten mindestens 100, größer sind als eine Breite des Druckträgers. Ein bevorzugter Druckträger beinhaltet, bevorzugt besteht aus, Papier, ein Folie oder ein Laminat. Ein bevorzugtes Laminat beinhaltet eine oder mehrere Polymerschichten, eine oder mehrere Papierschichten, eine oder mehrere Metallschichten, oder eine Kombination der vorgenannten Schichten in einer Schichtfolge.

### Druckfarbe

Druckfarben sind farbmittelhaltige Gemische, die eine geeignete Viskosität zu einem Auftragen als dünne Schicht haben. Hierbei hat die dünne Schicht in ausgehärtetem Zustand bevorzugt eine Dicke (Trockendicke) in einem Bereich von 0,5 bis 50 µm, bevorzugt von 1 bis 30 µm, bevorzugter von 1 bis 20 µm. Eine bevorzugte Druckfarbe beinhaltet eines, ausgewählt aus der Gruppe, bestehend aus einem oder mehreren Farbmitteln, einem Bindemittel, einer Vehikel, und einem Additiv, oder eine Kombination aus mindestens zwei, bevorzugt alle, der Vorgenannten. Ein bevorzugtes Bindemittel ist hierbei ein Harz oder ein Polymer oder eine Mischung aus beiden. Ein bevorzugtes Vehikel ist ein Lösungsmittel. Ein bevorzugtes Additiv dient zu einem Einstellen einer gewünschten Eigenschaft der Druckfarbe, bevorzugt einer gewünschten Verarbeitungseigenschaft, beispielsweise einer Viskosität der Druckfarbe. Ein bevorzugtes Additiv ist eines, ausgewählt aus der Gruppe, bestehend aus einem Dispergieradditiv, einem Entschäumer, einem Wachs, einem Gleitmittel, und einem Substratnetzmittel, oder eine Kombination aus mindestens zwei davon. Ferner ist eine bevorzugte Druckfarbe eine, ausgewählt aus der Gruppe, bestehend aus einem Toner, einer Tinte für einen Tintenstrahldrucker, einer Offset-druckfarbe, einer Illustrationsdruckfarbe, einer Flüssigfarbe, und einer strahlenhärtendes Druckfarbe, oder eine Kombination aus mindestens zwei davon. Eine bevorzugte Offset-Druckfarbe ist eine Rollenoffset-Druckfarbe oder eine Bogenoffset-Druckfarbe oder beides. Eine bevorzugte Rollenoffset-Druckfarbe ist eine Rollenoffset-Coldsetdruckfarbe oder eine Rollenoffset-Heatsetdruckfarbe oder beides. Eine bevorzugte Flüssigfarbe ist eine wasserbasierte Flüssigfarbe oder eine lösemittelbasierte Flüssigfarbe oder beides. Eine besonders bevorzugte Druckfarbe beinhaltet zu 8 bis 15 Gew.-% mindestens ein Farbmittel, bevorzugt mindestens ein Pigmet, und zu insgesamt 25 bis 40 Gew.-% mindestens ein Harz oder mindestens ein Polymer oder eine Mischung der beiden, zu 30 bis 45 Gew.-% mindestens ein hochsiedendes Mineralöl (Siedebereich 250 bis 210 °C), und zu insgesamt 2 bis 8 Gew.-% mindestens ein Additiv, jeweils bezogen auf das Gewicht der Druckfarbe.

### Lack

Ein Lack ist ein flüssiger oder auch pulverförmiger Beschichtungsstoff, der eine geeignete Viskosität zu einem Auftragen als dünne Schicht hat und aus dem durch ein Härten ein fester, vorzugsweise zusammenhängender, Film erhältlich ist. Lacke beinhalten oftmals mindestens eines, ausgewählt aus der Gruppe, bestehend aus mindestens einem Bindemittel, mindestens einem Füllstoff, mindestens einem Vehikel, mindestens einem Farbmittel, mindestens einem Harz und/oder mindestens einem Acrylat, und mindestens einem Additiv, oder eine Kombination aus mindestens zwei davon, wobei eine Kombination aller vorgenannten Bestandteile (mit Harz und/oder Acrylat) bevorzugt ist. Ein bevorzugtes Additiv ist hierbei ein Biozid. Ein bevorzugtes Biozid ist ein Topf-Konservierer. Lacke dienen oftmals zum Schutz des damit versehenen Objekts, der Dekoration, eine Funktionalisierung einer Oberfläche des Objekts, beispielsweise einer Veränderung elektrischer Eigenschaften oder einer Beständigkeit gegen Abrieb, oder einer Kombination der vorgenannten Funktionen. Ein im Rahmen der Erfindung bevorzugter Lack ist einer, ausgewählt aus der Gruppe, bestehend aus einem wasserbasierten Lack, einem lösemittelbasierten Lack, einem UV-basierten, also UV-härtbaren, Lack, und einem Dispersionslack, oder eine Kombination aus mindestens zwei davon. Ein besonders bevorzugter Lack ist zum Schutz einer bedruckten Oberfläche ausgebildet.

### Farbmittel

Als Farbmittel kommen dem Fachmann bekannte und für die vorliegende Erfindung geeignete sowohl feste und flüssige in Betracht. Farbmittel ist nach DIN 55943:2001-10 die Sammelbezeichnung für alle farbgebenden Stoffe, insbesondere für Farbstoffe und Pigmente. Ein bevorzugtes Farbmittel ist ein Pigment. Ein bevorzugtes Pigment ist ein organisches Pigment. Im Zusammenhang mit der Erfindung beachtliche Pigmente sind insbesondere die in der DIN 55943:2001-10 und die in "Industrial Organic Pigments, Third Edition." (Willy Herbst, Klaus Hunger Copyright © 2004 WILEY-VCH Verlag GmbH & Co. KGaA, Weinheim ISBN: 3-527-30576-9) erwähnten Pigmente. Ein Pigment ist ein Farbmittel, das bevorzugt in dem Anwendungsmedium unlöslich ist. Ein Farbstoff ist ein Farbmittel, das bevorzugt in dem Anwendungsmedium löslich ist.

### Verfahrensschritte

In einem hierin beschriebenen Verfahren erfolgen die Verfahrensschritte einer Schrittfolge in der angegebenen Reihenfolge ihrer Ordnungszeichen. Dabei können die Schritte einer Schrittfolge mittelbar oder unmittelbar aufeinander folgen. Ferner können aufeinanderfolgende Verfahrensschritte zeitlich nacheinander, in zeitlichem Überlapp der auch gleichzeitig erfolgen.

### MESSMETHODEN

Sofern nichts anderes angegeben ist wurden die im Rahmen der Erfindung benutzt durchgeführten Messungen bei einer Umgebungstemperatur von 23°C, einem Umgebungsluftdruck von 100 kPa (0,986 atm) und einer relativen Luftfeuchtigkeit von 50 % durchgeführt.

Die Erfindung wird im Folgenden durch Beispiele und Zeichnungen genauer dargestellt, wobei die Beispiele und Zeichnungen keine Einschränkung der Erfindung bedeuten. Ferner sind die Zeichnungen sofern nicht anders angegeben nicht maßstabsgetreu.

Es zeigen jeweils sofern nicht anders in der Beschreibung oder der jeweiligen Figur angegeben schematisch und nicht maßstabsgetreu:
- Figur 1: eine schematische Darstellung einer erfindungsgemäßen Lichtquelle;
- Figur 2: eine schematische Teildarstellung eines Ausschnitts der erfindungsgemäßen Lichtquelle der Figur 1;
- Figur 3: eine weitere schematische Teildarstellung eines Ausschnitts der erfindungsgemäßen Lichtquelle der Figur 1;
- Figur 4: eine schematische Darstellung des ersten Trägerelements der erfindungsgemäßen Lichtquelle der Figur 1;
- Figur 5: eine schematische Querschnittsdarstellung der erfindungsgemäßen Lichtquelle der Figur 1;
- Figur 6: ein Ablaufdiagramm eines erfindungsgemäßen Verfahrens zum Herstellen einer Lichtquelle;
- Figur 7: eine schematische Darstellung einer erfindungsgemäßen Druckmaschine;
- Figur 8: ein Ablaufdiagramm eines erfindungsgemäßen Verfahrens zum Herstellen eines Druckerzeugnisses;
- Figur 9: eine schematische Darstellung eines erfindungsgemäßen Druckerzeugnisses;
- Figur 10: eine schematische Darstellung einer erfindungsgemäßen Anordnung; und
- Figur 11: ein Ablaufdiagramm eines erfindungsgemäßen Verfahrens zu einem Bestrahlen eines Bestrahlungsguts.

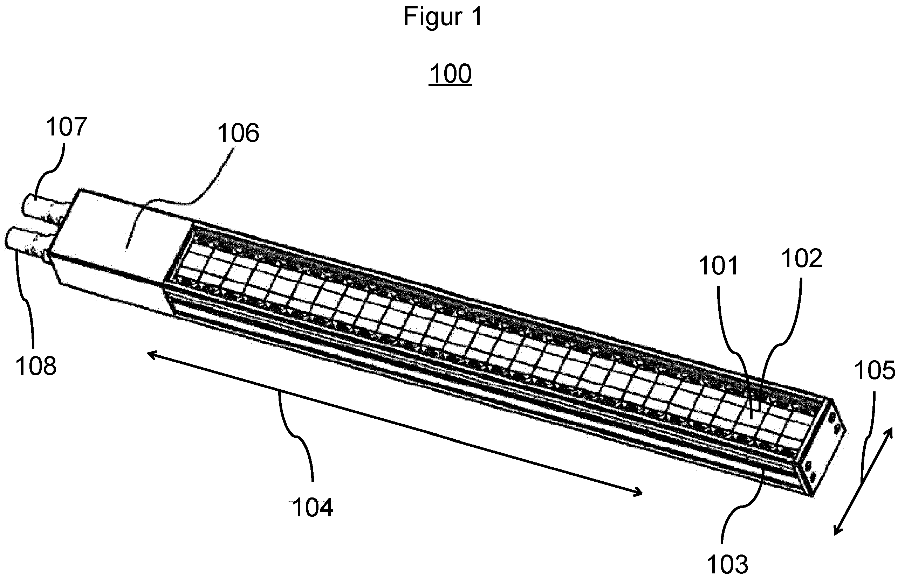

Figur 1 zeigt eine schematische Darstellung einer erfindungsgemäßen Lichtquelle 100. Die Lichtquelle 100 beinhaltet ein Verteilerelement 103 aus Aluminium. Das Verteilerelement 103 ist einstückig ausgebildet und in einer longitudinalen Richtung 104 längserstreckt. Eine transversale Richtung 105 ist zu der longitudinalen Richtung 104 senkrecht. Auf das Verteilerelement 103 sind insgesamt 28 Trägerelemente 102 geschraubt. Jedes der Trägerelemente 102 ist einzeln austauschbar. Ferner trägt jedes der Trägerelemente 102 ein lichtemittierendes Halbleiterbauelement 101, genauer ein LED-Modul 101. Die Lichtquelle 100 weist ferner einen Anschluss 107 für einen Kühlfluidzulauf und einen Anschluss 108 für einen Kühlfluidrücklauf eines Kühlkreislaufs auf. Die Anschlüsse 107 und 108 sind mittels eines Verbindungselements 106 mit dem Verteilerelement 103 verbunden. Das Verteilerelement 103 ist ferner als Gehäuse der Lichtquelle 100 ausgebildet.

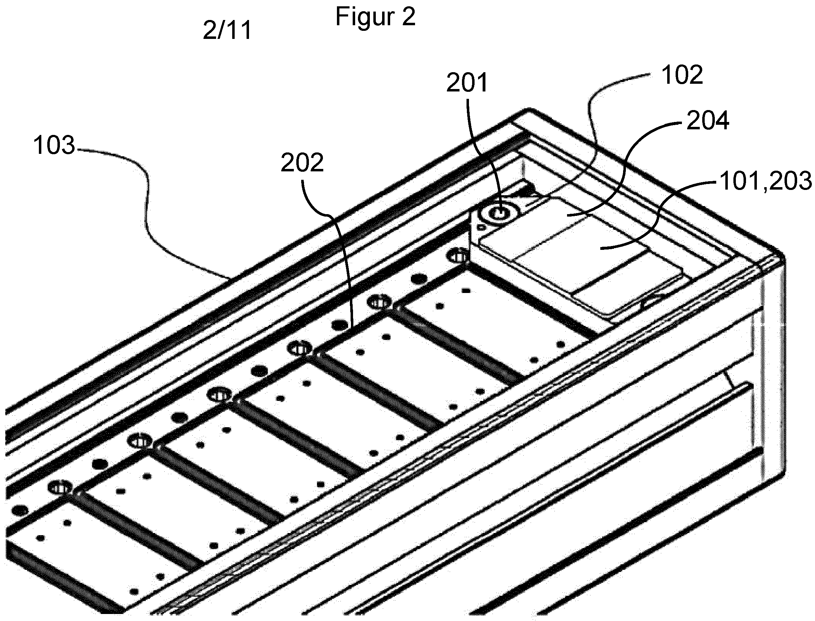

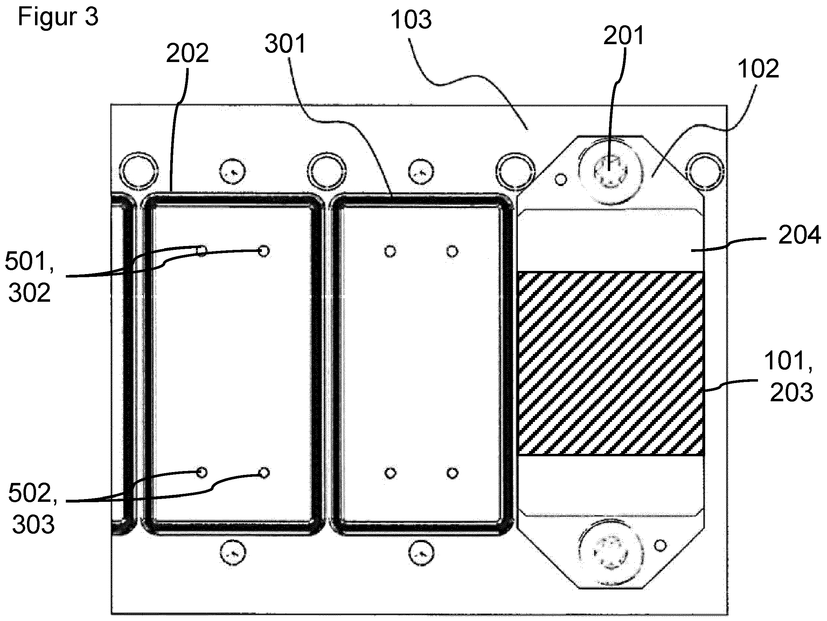

Figur 2 zeigt eine schematische Teildarstellung eines Ausschnitts der erfindungsgemäßen Lichtquelle 100 der Figur 1. In der Figur 2 ist nur ein erstes Trägerelement 102 der insgesamt 28 Trägerelemente 102 der Lichtquelle 100 dargestellt. Ein erstes lichtemittierendes Halbleiterbauelement 101, welches ein LED-Modul 101 ist, ist auf das erste Trägerelement 102 gelötet. Das erste Trägerelement 102 ist mit 2 Senkkopfschrauben als Befestigungsmittel 201 auf das Verteilerelement 103 geschraubt. Demnach überlagern das erste lichtemittierende Halbleiterbauelement 101, das erste Trägerelement 102 und das Verteilerelement 103 einander in der vorgenannten Reihenfolge. Das gezeigte LED-Modul 101 beinhaltet ein Substrat 204 aus einem keramischen Material, auf das mehrere LED-Chips 203 in Chip-On-Board-Technologie aufgebracht sind. Das LED-Modul 101 ist ein UV-LED-Modul. Das Verteilerelement 103 weist ferner in der longitudinalen Richtung 104 nebeneinander für jedes der 28 Trägerelemente 102 eine Dichtungsnut 202 zur Aufnahme eines Dichtungselements 301 (siehe Figur 3) auf.

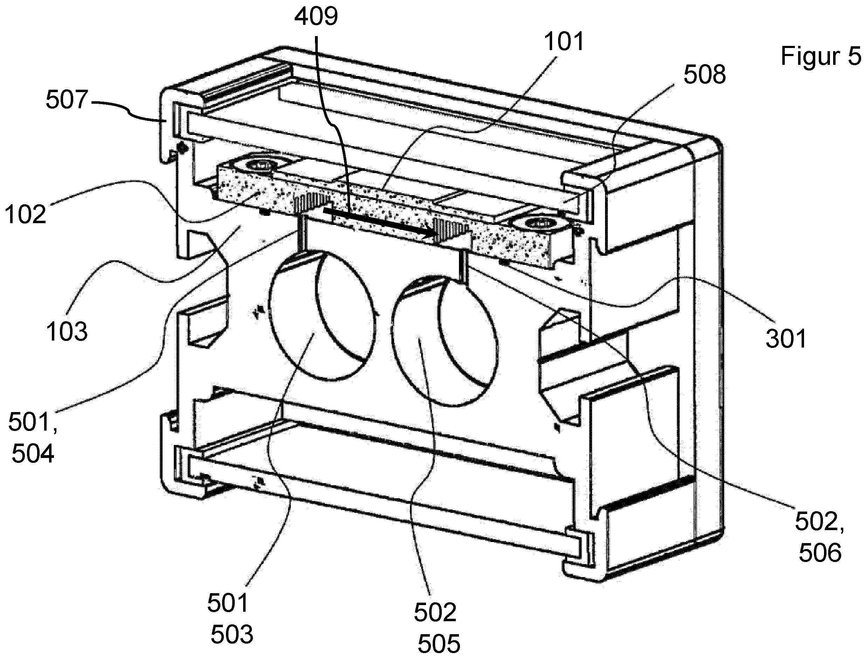

Figur 3 zeigt eine weitere schematische Teildarstellung eines Ausschnitts der erfindungsgemäßen Lichtquelle 100 der Figur 1. Wie in der der Figur 2 ist auch hier nur das erste Trägerelement 102 der insgesamt 28 Trägerelemente 102 der Lichtquelle 100 gezeigt. Ferner ist hier in jede Dichtungsnut 202 jeweils ein Dichtungselement 301 aufgenommen. Die Dichtungselemente 301 sind als O-Ringe rechteckiger Form ausgebildet. Bei montiertem Trägerelement 102 ist ein in eine Dichtungsnut 202 aufgenommenes Dichtungselement 301 zwischen dem Trägerelement 102 und dem Verteilerelement 103 so um eine fluidleitende Verbindung zwischen dem Trägerelement 102 und dem Verteilerelement 103 angeordnet, dass die fluidleitende Verbindung lateral fluiddicht abgedichtet ist. Ferner sind in der Figur 3 je Montageplatz eines nicht dargestellten weiteren Trägerelements 102 zwei dritte Kanäle 302 eines ersten Hohlraums 501 in dem Verteilerelement 103 und zwei dritte Kanäle 303 eines weiteren Hohlraums 502 in dem Verteilerelement 103 zu sehen. Der erste 501 und der weitere Hohlraum 502 werden unten zur Figur 5 erläutert.

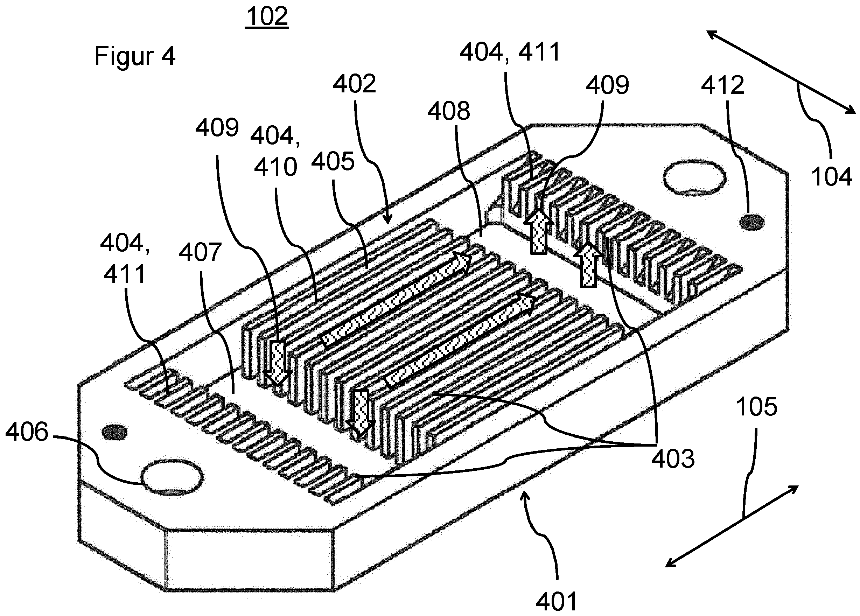

Figur 4 zeigt eine schematische Darstellung des ersten Trägerelements 102 der erfindungsgemäßen Lichtquelle 100 der Figur 1. Das erste Trägerelement 102 hat die Außenmaße 59,5 mm × 24,3 mm × 5 mm. Es besteht aus einem Grundkörper aus Kupfer der Werkstoffbezeichnung Cu-ETP R250 und der Werkstoffnummer CW004A. Auf diesen Grundkörper ist eine Nickelschicht mit einer Dicke von 3 bis 7 µm aufgebracht. Auf die Nickelschicht ist wiederum eine Goldschicht der Dicke von 0,03 bis 0,13 µm beschichtet. Bei den beiden Beschichtungen handelt es sich um im technischen Gebiet als *Electroless Nickel Immersion Gold* (ENIG) bezeichnete Beschichtungen, die insbesondere dem Oberflächenschutz dienen und zudem ein Aufbringen des LED-Moduls 101 auf eine eben ausgebildete Trägeroberfläche 401 des ersten Trägerelements 102 (in der Figur auf der verdeckten Unterseite des ersten Trägerelements 102) erleichtern. Das erste Trägerelement 102 weist ferner eine der Trägeroberfläche 401 gegenüberliegende Außenoberfläche auf, die hier als Kühloberfläche 402 bezeichnet wird. Diese Kühloberfläche 402 ist teilweise eine Oberfläche einer Kühlstruktur 403, die aus 13 Kühlrippen 404 und 14 Kanälen 405 besteht. Die Kanäle 405 führen, abgesehen von den beiden äußersten Kanälen 405, zwischen jeweils zwei benachbarten Kühlrippen 404 hindurch. Jede der Kühlrippen 404 hat eine Dicke von 0,65 mm. Eine Breite der Kanäle 405 bemisst sich auf etwa 0,82 mm. Die Kühlrippen 404 weisen jeweils zwei Unterbrechungen auf. Ein Verteilerraum 407 bildet jeweils eine Unterbrechung der Kühlrippen 404 während ein Sammelraum 408 die zweite Unterbrechung jeder Kühlrippe 404 bildet. In den Kanälen 405, im Verteilerraum 407 und im Sammelraum 408 ist eine Dicke des ersten Trägerelements 102 am geringsten. Diese geringste Dicke beträgt 1 mm. Diese Materialstärke verleiht dem ersten Trägerelement 102 eine ausreichende mechanische Stabilität für die Montage des LED-Moduls 101 mittels Kleben, Löten oder Sintern. Ferner ist das erste Trägerelement 102 mit dieser Materialstärke ausreichend mechanisch stabil, um bei üblichen Druckschlägen im Kühlkreislauf keinen Schaden zu nehmen. Hierbei kann durch die gewählte Materialstärke ferner eine ausreichende Wärmeabgabe des ersten Trägerelements 102 an ein Kühlfluid erreicht werden. Das Kühlfluid kann einen ersten Fluidweg 409, der in der Figur durch Pfeile angedeutet ist, entlangströmen. Dieser erste Fluidweg 409 verbindet den ersten Hohlraum 501 und den weiteren Hohlraum 502 des Verteilerelements 103 fluidleitend miteinander (siehe Figur 5). Der erste Fluidweg 409 führt von dem ersten Hohlraum 501 des Verteilerelements 102 kommend (hier nicht gezeigt) in den Verteilerraum 407, durch die 14 Kanäle 405 in den Sammelraum 408 und von dort in den weiteren Hohlraum 502 des Verteilerelements (hier nicht gezeigt). Demnach begrenzt die Kühloberfläche 402 den ersten Fluidweg 409 teilweise. Der Verteilerraum 407 ist dazu angeordnet und ausgebildet, das entlang des ersten Fluidwegs 409 strömende Kühlfluid auf die Kanäle 405 zu verteilen. Analog dazu ist der Sammelraum 408 dazu angeordnet und ausgebildet, das aus den Kanälen 405 herausströmende Kühlfluid in den weiteren Hohlraum 502 zu leiten. Jede der Kühlrippen 404 besteht aus einem ersten Abschnitt 410 und zwei weiteren Abschnitten 411. Die Abschnitte 410, 411 werden jeweils durch Unterbrechungen in Form des Verteilerraums 407 oder des Sammelraums 408 voneinander getrennt. Die ersten Abschnitte 410 befinden sich in dem ersten Fluidweg 409, die weiteren Abschnitte 411 nicht. Dennoch tragen die weiteren Abschnitte 411 zu einer guten Verteilung des Kühlfluids und somit zu einer homogenen Kühlung des ersten Trägerelements 102 bei. In den ersten Abschnitten 410 ist eine Höhe der Kühlrippen 404 konstant. In den weiteren Abschnitten 411 nimmt eine Höhe der Kühlrippen 404 in der transversalen Richtung 105 nach außen hin, also in einer zu den Dicken und Höhen der Kühlrippen 404 senkrechten Richtung, die von den ersten Abschnitten 410 weggerichtet ist, ab. Dies liegt daran, dass eine Tiefe der Kanäle 405 in den weiteren Abschnitten 411 in der transversalen Richtung 105 nach außen abnimmt. Das erste Trägerelement 102 weist ferner Durchgangsgewinde 412 auf. Diese M2-Gewinde können zur Befestigung von Anbauteilen wie Halterungen für Optiken, oder auch zur Befestigung von Montagehilfen, beispielsweise einer Schutzkappe für das LED-Modul 101, genutzt werden. Durch die Durchgangslöcher 406 können die oben genannten Senkkopfschrauben zum lösbaren Befestigen des ersten Trägerelements 102 an dem Verteilerelement hindurchgeführt werden. Jedes weitere Trägerelement 102 der 28 Trägerelemente 102 der Lichtquelle 100 ist wie das vorstehend beschriebene erste Trägerelement 102 ausgebildet.

Figur 5 zeigt eine schematische Querschnittsdarstellung der erfindungsgemäßen Lichtquelle 100 der Figur 1. Hier ist zu erkennen, dass das Verteilerelement 103 einen ersten Hohlraum 501 beinhaltet, der als Zulauf für das Kühlfluid ausgebildet ist. Der erste Hohlraum 501 umfasst einen ersten Kanal 503, welcher unter jedes der Trägerelemente 102 hindurch führt. Von dem ersten Kanal 503 führen zwei zweite Kanäle 504 des ersten Hohlraums 501 in den ersten Fluidweg 409. Für jedes weitere Trägerelement 102 führen je zwei dritte Kanäle 302 des ersten Hohlraums 501 in einen weiteren Fluidweg, also zu der Kühloberfläche 402 des jeweiligen Trägerelements 102 (vgl. Figur 3). Ferner beinhaltet das Verteilerelement 103 einen weiteren Hohlraum 502, der als Rücklauf für das Kühlfluid ausgebildet ist. Der weitere Hohlraum 502 umfasst einen ersten Kanal 505, der unter jedes der 28 Trägerelemente 102 hindurch führt. Von dem ersten Fluidweg 409 führen zwei zweite Kanäle 506 des weiteren Hohlraums 502 in dessen ersten Kanal 505. Für jedes weitere Trägerelement 102 führen je zwei dritte Kanäle 303 des weiteren Hohlraums 502 von einem weiteren Fluidweg, also von der Kühloberfläche 402 des jeweiligen weiteren Trägerelements 102, in den ersten Kanal 505. (vgl. Figur 3). Mittels des ersten Fluidwegs 409 und jedes weiteren Fluidwegs sind demnach der erste Hohlraum 501 und der weitere Hohlraum 502 fluidleitend miteinander verbunden. Ferner ist in der Figur 5 zu sehen, dass der in der Figur durch einen Pfeil angedeutete erste Fluidweg 409 durch die erste Kühloberfläche 402 und eine gegenüberliegende Außenoberfläche des Verteilerelements 103 begrenzt wird. Zu sehen ist ferner, das zwischen dem ersten Trägerelement 102 und dem Verteilerelement zum Abdichten angeordnete erste Dichtungselement 301. Das Verteilerelement 103 in seiner Funktion als Gehäuse weist ferner eine Halterung 507 auf, die dazu angeordnet und ausgebildet ist, ein Emissionsfenster 508 der Lichtquelle 100 zu halten.

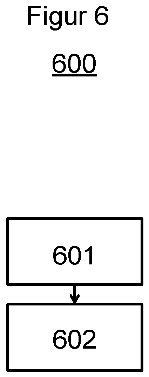

Figur 6 zeigt ein Ablaufdiagramm eines erfindungsgemäßen Verfahrens zum Herstellen einer Lichtquelle 100. In einem Verfahrensschritt A} 601 werden 28 Trägerelemente 102 bereitgestellt, die wie das in Figur 4 gezeigte erste Trägerelement 102 ausgebildet sind, bereitgestellt. Auf der Trägeroberfläche 401 jedes dieser Trägerelemente 102 ist ein LED-Modul 101 aufgebracht. Ferner wird in diesem Verfahrensschritt A} 601 das in Figur 5 gezeigte Verteilerelement 103 bereitgestellt. In einem Verfahrensschritt B} werden die Trägerelemente 102 jeweils mittels zwei Senkkopfschrauben lösbar auf das Verteilerelement 103 geschraubt, so dass der erste Hohlraum 51 und der weitere Hohlraum 502 des Verteilerelements 103 für jedes Trägerelement 102 fluidleitend mittels eines Fluidwegs 409 miteinander verbunden sind. Hierbei wird jeder der Fluidwege 409 durch eine Oberfläche des Verteilerelements 103 und durch eine Kühloberfläche 402 des jeweiligen Trägerelements 102 begrenzt. Das Bereitstellen des Verteilerelements 103 beinhaltet ein Strangpressen unter Erhalt eines Aluminiumformkörpers, in den durch Bohren die zweiten Kanäle 504 und 506 sowie die dritten Kanäle 302 und 303 eingebracht werden. Das Bereitstellen jedes der Trägerelemente 102 erfolgt mittels Bereitstellen eines Kupferformkörpers, Bearbeiten dieses Kupferformkörpers, unter anderem mit einer CNC-Fräsmaschine, und Beschichten des bearbeiteten Kupferformköpers mit den ENIG-Beschichtungen. Das Bearbeiten mit der CNC-Fräsmaschine beinhaltet ein Fräsen mit einem Scheibenfräser. Dieser hat 14 scheibenförmige Fräsblätter, die jeweils einen Durchmesser von 27,7 mm und eine Dicke von 0,82 mm haben. Mit diesem Scheibenfräser können gleichzeitig alle 14 Kanäle 405 und somit die Kühlrippen 404 der Kühlstruktur 403 des Trägerelements 102 erzeugt werden. Nachfolgend werden der Verteilerraum 407 und der Sammelraum 408 mit einem Schaftfräser eingebracht und so die Kühlrippen 404 in die ersten 410 und weiteren Abschnitte 411 unterteilt. Weiter werdend die Durchgangslöcher 406 gebohrt und die Durchgangsgewinde 412 gebohrt und geschnitten. Durch das Verfahren 600 wird die Lichtquelle 100 der Figur 1 hergestellt. Hierbei zeichnet sich das Verfahren 600 durch eine geringe Fertigungszeit, eine stabile Prozessführung (geringe Fertigungstoleranzen) und einen geringen Werkzeugverschleiß, insbesondere bei der Herstellung der Trägerelemente 102, aus. Ferner lässt sich das Kupfer der Trägerelemente 102 mit den genannten Werkzeugen leicht bearbeiten.

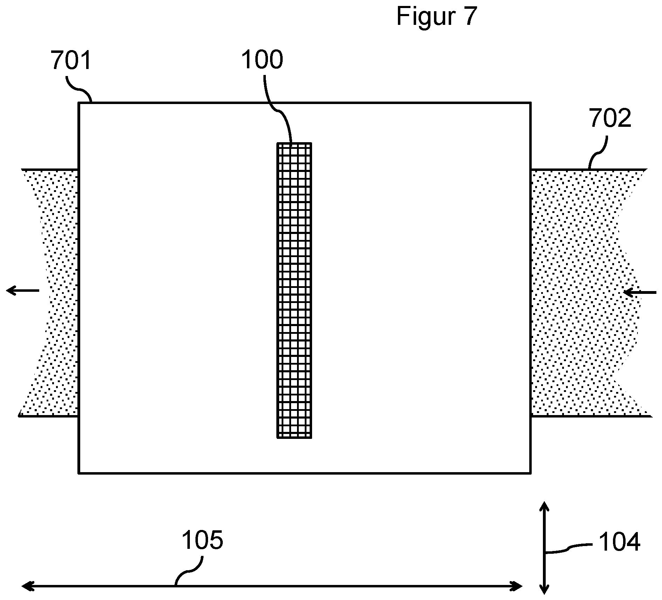

Figur 7 zeigt eine schematische Darstellung einer erfindungsgemäßen Druckmaschine 701. Die Druckmaschine 701 beinhaltet die Lichtquelle 100 der Figur 1. Die Lichtquelle 100 ist in der Druckmaschine 701 zu einem Bestrahlen einer auf einen Druckträger 702 gedruckten Zusammensetzung angeordnet. Bei der Druckmaschine 701 handelt es sich um eine Bogenoffset-Druckmaschine.

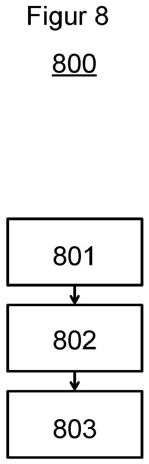

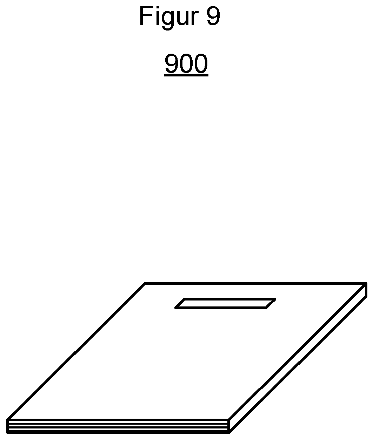

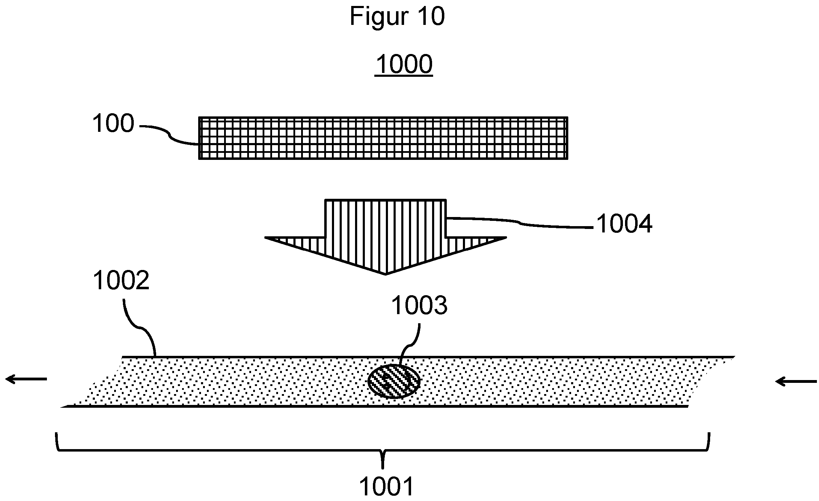

Figur 8 zeigt ein Ablaufdiagramm eines erfindungsgemäßen Verfahrens 800 zum Herstellen eines Druckerzeugnisses 900 (vgl. Figur 9). In einem Verfahrensschritt A) 801 werden die Druckmaschine 701 der Figur 7 und ein Druckträger 1002 als Objekt 1002 bereitgestellt (vgl. Figur 10). In einem nachfolgenden Verfahrensschritt B) 802 wird eine flüssige Zusammensetzung 1003, die eine Bogenoffset-Druckfarbe ist, mit der Druckmaschine 701 auf den Druckträger 1002 gedruckt. In einem Verfahrensschritt C) 803 wird die aufgedruckte Bogenoffset-Druckfarbe mit von den LED-Modulen 101 der Lichtquelle 100 abgestrahltem UV-Licht bestrahlt und dadurch mittels Polymerisieren gehärtet. Durch den erfindungsgemäßen Aufbau der Lichtquelle 100 kann jedes der 28 Trägerelemente der Lichtquelle 100 in dem Verfahrensschritt C) 803 mittels eines Wasser-Glykol-Gemischs als Kühlfluid, welches bei etwa 5 bar in einem Kühlkreislauf strömt, mit einer Kühlleistung von etwa 300 W gekühlt werden, so dass die beiden in der longitudinalen Richtung 104 am weitesten voneinander entfernt liegenden Trägerelemente 102 eine Temperaturdifferenz von maximal 4 K zeigen. Hierdurch können alle LED-Module 101 der Lichtquelle 100 bei etwa gleichem Wirkungsgrad betrieben werden, wodurch ein homogenes Bestrahlen und damit homogenes Härten der Druckfarbe 1003 über eine große Fläche möglich ist.

Figur 9 zeigt eine schematische Darstellung eines erfindungsgemäßen Druckerzeugnisses 900. Hierbei handelt es sich um ein nach dem Verfahren 800 der Figur 8 erhältlichen Prospekt 900.

Figur 10 zeigt eine schematische Darstellung einer erfindungsgemäßen Anordnung 1000. Diese umfasst die Druckmaschine 701 der Figur 7 und ein Bestrahlungsgut 1001, welches aus einem Objekt 1002, hier ein Druckträger 1002, und einer auf den Druckträger 1002 gedruckten Druckfarbe 1003 besteht. Die Lichtquelle 100 der Druckmaschine 701 und das Bestrahlungsgut 1001 sind so angeordnet, dass die aufgedruckte Druckfarbe 1003 mit von den LED-Modulen 101 der Lichtquelle 100 abgestrahltem Licht 1004, hier UV-Licht, bestrahlt werden kann.

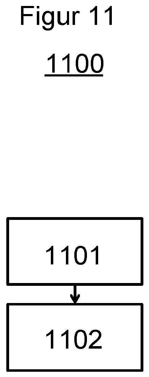

Figur 11 zeigt ein Ablaufdiagramm eines erfindungsgemäßen Verfahrens 1100 zu einem Bestrahlen eines Bestrahlungsguts 1001. In einem Verfahrensschritt A] 1101 wird die Anordnung 1000 der Figur 10 bereitgestellt. In einem Verfahrensschritt B] 1102 wird das Bestrahlungsgut 1001 mit von den LED-Modulen 101 der Lichtquelle 100 abgestrahltem UV-Licht bestrahlt.

Die Erfindung wird durch die beigefügten Ansprüche definiert.

### LISTE DER BEZUGSZEICHEN

- **100**: erfindungsgemäße Lichtquelle
- **101**: lichtemittierendes Halbleiterbauelement / LED-Modul
- **102**: Trägerelement
- **103**: Verteilerelement
- **104**: longitudinale Richtung
- **105**: transversale Richtung
- **106**: Verbindungselement
- **107**: Anschluss für Kühlfluidzulauf
- **108**: Anschluss für Kühlfluidrücklauf
- **201**: Befestigungsmittel / Schraube
- **202**: Dichtungsnut
- **203**: LED-Chips
- **204**: LED-Substrat
- **301**: Dichtungselement
- **302**: dritter Kanal des ersten Hohlraums
- **303**: dritter Kanal des weiteren Hohlraums
- **401**: erste Trägeroberfläche
- **402**: erste Kühloberfläche
- **403**: Kühlstruktur
- **404**: Kühlrippe
- **405**: Kanal zwischen zwei benachbarten Kühlrippen
- **406**: Durchgangsloch
- **407**: Verteilerraum
- **408**: Sammelraum
- **409**: erster Fluidweg
- **410**: erster Abschnitt
- **411**: weiterer Abschnitt
- **412**: Durchgangsgewinde
- **501**: erster Hohlraum
- **502**: weiterer Hohlraum
- **503**: erster Kanal des ersten Hohlraums
- **504**: zweiter Kanal des ersten Hohlraums
- **505**: erster Kanal des weiteren Hohlraums
- **506**: zweiter Kanal des weiteren Hohlraums
- **507**: Halterung
- **508**: Emissionsfenster
- **600**: erfindungsgemäßes Verfahren zum Herstellen einer Lichtquelle
- **601**: Verfahrensschritt A}
- **602**: Verfahrensschritt B}
- **701**: erfindungsgemäße Druckmaschine
- **702**: Druckträger
- **800**: erfindungsgemäßes Verfahren zum Herstellen eines Druckerzeugnisses
- **801**: Verfahrensschritt A)
- **802**: Verfahrensschritt B)
- **803**: Verfahrensschritt C)
- **900**: erfindungsgemäßes Druckerzeugnis / Prospekt
- **1000**: erfindungsgemäße Anordnung
- **1001**: Bestrahlungsgut
- **1002**: Objekt / Druckträger
- **1003**: Zusammensetzung / Druckfarbe
- **1004**: Licht
- **1100**: erfindungsgemäßes Verfahren zu einem Bestrahlen eines Bestrahlungsguts
- **1101**: Verfahrensschritt A]
- **1102**: Verfahrensschritt B]

## Patentansprüche

1. Eine Lichtquelle (100), beinhaltend als einander in dieser Reihenfolge überlagernde Bauteile
a) mindestens ein erstes lichtemittierendes Halbleiterbauelement (101);
b) ein erstes Trägerelement (102), beinhaltend
i) eine dem mindestens einen ersten lichtemittierenden Halbleiterbauelement (101) zugewandte erste Trägeroberfläche (401), und
ii) zusätzlich eine erste Kühloberfläche (402); und
c) ein Verteilerelement (103), beinhaltend
i) einen ersten Hohlraum (501), und
ii) einen weiteren Hohlraum (502);
wobei der erste Hohlraum (501) und der weitere Hohlraum (502) fluidleitend mittels eines ersten Fluidwegs (409) miteinander verbunden sind;
wobei der erste Fluidweg (409) mindestens teilweise durch die erste Kühloberfläche (402) begrenzt wird;
wobei die erste Trägeroberfläche (401) und die erste Kühloberfläche (402) einander gegenüberliegende äußere Oberflächen des ersten Trägerelements (102) sind;
wobei das Verteilerelement (103) in einer longitudinalen Richtung (104) längserstreckt ist;
wobei der erste Hohlraum (501)
a] einen ersten Kanal (503) beinhaltet, der sich in der longitudinalen Richtung (104) längserstreckt, und
b] zusätzlich einen zweiten Kanal (504), der sich von dem ersten Kanal (503) in Richtung des ersten Trägerelements (102) längserstreckt,
wobei der erste Kanal (503) und der zweite Kanal (504) des ersten Hohlraums (501) fluidleitend miteinander verbunden sind,
wobei ein Durchmesser des ersten Kanals (503) des ersten Hohlraums (501) mehr ist als ein Durchmesser des zweiten Kanals (504) des ersten Hohlraums (501);
wobei der weitere Hohlraum (502)
a} einen ersten Kanal (505) beinhaltet, der sich in der longitudinalen Richtung (104) längserstreckt, und
b} zusätzlich einen zweiten Kanal (506), der sich von dem ersten Kanal (505) in Richtung des ersten Trägerelements (102) längserstreckt,
wobei der erste Kanal (505) und der zweite Kanal (506) des weiteren Hohlraums (502) fluidleitend miteinander verbunden sind,
wobei ein Durchmesser des ersten Kanals (505) des weiteren Hohlraums (502) mehr ist als ein Durchmesser des zweiten Kanals (506) des weiteren Hohlraums (502).

2. Die Lichtquelle (100) nach Anspruch 1, wobei das erste Trägerelement (102) lösbar mit dem Verteilerelement (103) verbunden ist.

3. Die Lichtquelle (100) nach Anspruch 1 oder 2, wobei die Kühloberfläche (402) mindestens teilweise eine Oberfläche einer Kühlstruktur (403) des ersten Trägerelements (102) ist.

4. Die Lichtquelle (100) nach Anspruch 3, wobei die Kühlstruktur (403) eine Vielzahl von Kühlrippen (404) beinhaltet.

5. Die Lichtquelle (100) nach einem der vorhergehenden Ansprüche, wobei der erste Fluidweg (409) zusätzlich mindestens teilweise durch eine dem ersten Trägerelement (102) zugewandte Oberfläche des Verteilerelements (103) begrenzt wird.

6. Ein Verfahren (600) zum Herstellen einer Lichtquelle (100), das Verfahren (600) beinhaltend als Verfahrensschritte
A} Bereitstellen
a) mindestens eines ersten lichtemittierenden Halbleiterbauelements (101),
b) eines ersten Trägerelements (102), beinhaltend
i) eine erste Trägeroberfläche (401), und
ii) zusätzlich eine erste Kühloberfläche (401), und
c) eines Verteilerelement (101), beinhaltend
i) einen ersten Hohlraum (501), und
ii) einen weiteren Hohlraum (502); und
B} Lösbares Verbinden des ersten Trägerelements (102) mit dem Verteilerelement (103), so dass der erste Hohlraum (501) und der weitere Hohlraum (502) fluidleitend mittels eines ersten Fluidwegs (409) miteinander verbunden sind;
wobei das mindestens eine erste lichtemittierende Halbleiterbauelement (101) das erste Trägerelement (102) auf einer Seite der ersten Trägeroberfläche (401) überlagert; wobei der erste Fluidweg (409) mindestens teilweise durch die erste Kühloberfläche (402) begrenzt wird;
wobei die erste Trägeroberfläche (401) und die erste Kühloberfläche (402) einander gegenüberliegende äußere Oberflächen des ersten Trägerelements (102) sind;
wobei das Verteilerelement (103) in einer longitudinalen Richtung (104) längserstreckt ist;
wobei der erste Hohlraum (501)
a] einen ersten Kanal (503) beinhaltet, der sich in der longitudinalen Richtung (104) längserstreckt, und
b] zusätzlich einen zweiten Kanal (504), der sich von dem ersten Kanal (503) in Richtung des ersten Trägerelements (102) längserstreckt,
wobei der erste Kanal (503) und der zweite Kanal (504) des ersten Hohlraums (501) fluidleitend miteinander verbunden sind,
wobei ein Durchmesser des ersten Kanals (503) des ersten Hohlraums (501) mehr ist als ein Durchmesser des zweiten Kanals (504) des ersten Hohlraums (501);
wobei der weitere Hohlraum (502)
a} einen ersten Kanal (505) beinhaltet, der sich in der longitudinalen Richtung (104) längserstreckt, und
b} zusätzlich einen zweiten Kanal (506), der sich von dem ersten Kanal (505) in Richtung des ersten Trägerelements (102) längserstreckt,
wobei der erste Kanal (505) und der zweite Kanal (506) des weiteren Hohlraums (502) fluidleitend miteinander verbunden sind,
wobei ein Durchmesser des ersten Kanals (505) des weiteren Hohlraums (502) mehr ist als ein Durchmesser des zweiten Kanals (506) des weiteren Hohlraums (502).

7. Das Verfahren (600) nach Anspruch 6, wobei die erste Kühloberfläche (401) mindestens teilweise eine Oberfläche einer Kühlstruktur (403) des ersten Trägerelements (102) ist,
wobei in dem Verfahrensschritt A} (601) das Bereitstellen des ersten Trägerelements (102) ein Erzeugen der Kühlstruktur (403) mittels eines Scheibenfräsers beinhaltet.

8. Eine Druckmaschine (701), beinhaltend die Lichtquelle (100) nach einem der Ansprüche 1 bis 5.

9. Ein Verfahren (800), beinhaltend als Verfahrensschritte
A) Bereitstellen
I) der Lichtquelle (100) nach einem der Ansprüche 1 bis 5, und
II) eines Objekts (1002);
B) Überlagern des Objekts (1002) mit einer Zusammensetzung (1003); und
C) Bestrahlen der Zusammensetzung (1003) mit von dem mindestens einen ersten lichtemittierenden Halbleiterbauelement (101) abgestrahltem Licht (1004).

10. Das Verfahren (800) nach Anspruch 9, wobei der Verfahrensschritt C) ein Härten der Zusammensetzung (1003) beinhaltet,
wobei das Härten ein Verringern eines Anteils eines Vehikels in der Zusammensetzung (1003) beinhaltet.

11. Eine Anordnung (1000), beinhaltend
A. die Lichtquelle (100) nach einem der Ansprüche 1 bis 5, und
B. ein Bestrahlungsgut (1001),
wobei die Lichtquelle und das Bestrahlungsgut (1001) zu einem Bestrahlen des Bestrahlungsguts (1001) mit von dem mindestens einen ersten lichtemittierenden Halbleiterbauelement (101) abgestrahltem Licht (1003) angeordnet und ausgebildet sind.

12. Ein Verfahren (1100), beinhaltend als Verfahrensschritte
A] Bereitstellen der Anordnung (1000) nach Anspruch 11; und
B] Bestrahlen des Bestrahlungsguts (1001) mit von dem mindestens einen ersten lichtemittierenden Halbleiterbauelement (101) abgestrahltem Licht (1004).

13. Eine Verwendung der Lichtquelle (100) nach einem der Ansprüche 1 bis 5 zu einem Härten einer Zusammensetzung (1003).

14. Eine Verwendung der Lichtquelle (100) nach einem der Ansprüche 1 bis 5 in einer Druckmaschine (701).

## Claims

1. A light source (100) comprising, as components superimposed on each other in this order
a) at least one first light-emitting semiconductor component (101);
b) a first carrier element (102) comprising
i) a first support surface (401) facing the at least one first light-emitting semiconductor device (101), and
ii) additionally a first cooling surface (402); and
c) a distribution element (103) comprising
i) a first cavity (501), and
ii) a further cavity (502);
wherein the first cavity (501) and the further cavity (502) are connected to each other in a fluid-conducting manner by means of a first fluid path (409);
wherein the first fluid path (409) is at least partially bounded by the first cooling surface (402);
wherein the first carrier surface (401) and the first cooling surface (402) are opposite outer surfaces of the first carrier element (102);
wherein the distribution element (103) is elongated in a longitudinal direction (104); wherein the first cavity (501)
a] includes a first channel (503) extending longitudinally in the longitudinal direction (104), and
b] additionally includes a second channel (504) extending longitudinally from the first channel (503) towards the first support element (102),
wherein the first channel (503) and the second channel (504) of the first cavity (501) are fluidically connected to each other,
wherein a diameter of the first channel (503) of the first cavity (501) is greater than a diameter of the second channel (504) of the first cavity (501);
wherein the further cavity (502)
a} includes a first channel (505) extending longitudinally in the longitudinal direction (104), and
b} additionally includes a second channel (506) which extends longitudinally from the first channel (505) in the direction of the first carrier element (102),
wherein the first channel (505) and the second channel (506) of the further cavity (502) are fluidically connected to each other,
wherein a diameter of the first channel (505) of the further cavity (502) is greater than a diameter of the second channel (506) of the further cavity (502).

2. The light source (100) according to claim 1, wherein the first carrier element (102) is detachably connected to the distributor element (103).

3. The light source (100) according to claim 1 or 2, wherein the cooling surface (402) is at least partially a surface of a cooling structure (403) of the first carrier element (102).

4. The light source (100) according to claim 3, wherein the cooling structure (403) includes a plurality of cooling fins (404).

5. The light source (100) according to one of the preceding claims, wherein the first fluid path (409) is additionally at least partially bounded by a surface of the distribution element (103) facing the first carrier element (102).

6. A method (600) for manufacturing a light source (100), the method (600) comprising the following steps
A} providing
a) at least one first light-emitting semiconductor device (101),
b) a first carrier element (102) comprising
i) a first carrier surface (401), and
ii) additionally a first cooling surface (401), and
c) a distribution element (101) comprising
i) a first cavity (501), and
ii) a further cavity (502); and
B} detachably connecting the first carrier element (102) to the distributor element (103) so that the first cavity (501) and the further cavity (502) are connected to each other in a fluid-conducting manner by means of a first fluid path (409);
wherein the at least one first light-emitting semiconductor device (101) overlays the first carrier element (102) on one side of the first carrier surface (401);
wherein the first fluid path (409) is at least partially bounded by the first cooling surface (402);
wherein the first support surface (401) and the first cooling surface (402) are opposite outer surfaces of the first support element (102);
wherein the distribution element (103) is elongated in a longitudinal direction (104); wherein the first cavity (501)
a] includes a first channel (503) extending longitudinally in the longitudinal direction (104), and
b] additionally includes a second channel (504) extending longitudinally from the first channel (503) towards the first support element (102),
wherein the first channel (503) and the second channel (504) of the first cavity (501) are fluidically connected to each other,
wherein a diameter of the first channel (503) of the first cavity (501) is greater than a diameter of the second channel (504) of the first cavity (501);
wherein the further cavity (502)
a} includes a first channel (505) extending longitudinally in the longitudinal direction (104), and
b} additionally includes a second channel (506) which extends longitudinally from the first channel (505) in the direction of the first carrier element (102),
wherein the first channel (505) and the second channel (506) of the further cavity (502) are fluidically connected to each other,
wherein a diameter of the first channel (505) of the further cavity (502) is greater than a diameter of the second channel (506) of the further cavity (502).

7. The method (600) according to claim 6, wherein the first cooling surface (401) is at least partially a surface of a cooling structure (403) of the first carrier element (102), wherein, in process step A} (601), providing the first carrier element (102) includes creating the cooling structure (403) by means of a disc cutter.

8. A printing machine (701) comprising the light source (100) according to any one of claims 1 to 5.

9. A method (800) comprising the following method steps
A) providing
I) the light source (100) according to one of claims 1 to 5, and
II) an object (1002);
B) superpositioning the object (1002) with a composition (1003); and
C) irradiating the composition (1003) with light (1004) emitted by the at least one first light-emitting semiconductor device (101).

10. The method (800) according to claim 9, wherein process step C) includes curing the composition (1003).
wherein the curing involves reducing a proportion of a vehicle in the composition (1003).

11. An arrangement (1000) comprising
A. the light source (100) according to any one of claims 1 to 5, and
B. an irradiation object (1001),
wherein the light source and the irradiation object (1001) are arranged and designed to irradiate the irradiation object (1001) with light (1003) emitted by the at least one first light-emitting semiconductor device (101).

12. A method (1100) comprising the steps of
A] providing the arrangement (1000) according to claim 11; and
B] irradiating the irradiation material (1001) with light (1004) emitted by the at least one first light-emitting semiconductor device (101).

13. Use of the light source (100) according to any one of claims 1 to 5 for curing a composition (1003).

14. Use of the light source (100) according to any one of claims 1 to 5 in a printing machine (701).

## Revendications

1. Une source lumineuse (100) comprenant, en tant qu'éléments superposés dans cet ordre
a) au moins un premier composant semi-conducteur émettant de la lumière (101) ;
b) un premier élément de support (102) comprenant
i) une première surface de support (401) tournée vers le au moins un premier composant semi-conducteur émetteur de lumière (101), et
ii) en outre une première surface de refroidissement (402) ; et
c) un élément de distribution (103) comprenant
i) une première cavité (501), et
ii) une autre cavité (502) ;
la première cavité (501) et l'autre cavité (502) étant reliées entre elles de manière à permettre le passage d'un fluide au moyen d'un premier chemin de fluide (409) ;
le premier chemin de fluide (409) étant au moins partiellement délimité par la première surface de refroidissement (402) ;
la première surface de support (401) et la première surface de refroidissement (402) étant des surfaces extérieures opposées du premier élément de support (102) ;
l'élément de distribution (103) s'étendant longitudinalement dans une direction longitudinale (104) ;
la première cavité (501)
a] comprend un premier canal (503) qui s'étend longitudinalement dans la direction longitudinale (104), et
b] comprend en outre un deuxième canal (504) qui s'étend longitudinalement à partir du premier canal (503) en direction du premier élément de support (102),
le premier canal (503) et le deuxième canal (504) de la première cavité (501) étant reliés entre eux de manière à permettre le passage de fluide,
le diamètre du premier canal (503) de la première cavité (501) étant supérieur au diamètre du deuxième canal (504) de la première cavité (501) ;
la cavité supplémentaire (502)
a} comprend un premier canal (505) qui s'étend longitudinalement dans la direction longitudinale (104), et
b} comprend en outre un deuxième canal (506) qui s'étend longitudinalement à partir du premier canal (505) en direction du premier élément de support (102),
le premier canal (505) et le deuxième canal (506) de l'autre cavité (502) étant reliés entre eux de manière à permettre le passage de fluide,
le diamètre du premier canal (505) de la cavité supplémentaire (502) étant supérieur que le diamètre du deuxième canal (506) de la cavité supplémentaire (502).

2. La source lumineuse (100) selon la revendication 1, dans laquelle le premier élément de support (102) est relié de manière amovible à l'élément de distribution (103).

3. La source lumineuse (100) selon la revendication 1 ou 2, dans laquelle la surface de refroidissement (402) est au moins en partie une surface d'une structure de refroidissement (403) du premier élément de support (102).

4. La source lumineuse (100) selon la revendication 3, dans laquelle la structure de refroidissement (403) comprend une pluralité d'ailettes de refroidissement (404).

5. La source lumineuse (100) selon l'une des revendications précédentes, dans laquelle le premier chemin de fluide (409) est en outre délimité au moins en partie par une surface de l'élément de distribution (103) tournée vers le premier élément de support (102).

6. Un procédé (600) de fabrication d'une source lumineuse (100), le procédé (600) comprenant les étapes suivantes
A} la fourniture
a) au moins un premier composant semi-conducteur émettant de la lumière (101),
b) un premier élément de support (102) comprenant
i) une première surface de support (401), et
ii) en outre une première surface de refroidissement (401), et
c) un élément de distribution (101) comprenant
i) une première cavité (501), et
ii) une autre cavité (502) ; et
B} la connexion amovible du premier élément de support (102) à l'élément de distribution (103), de sorte que la première cavité (501) et l'autre cavité (502) sont reliées entre elles de manière à permettre le passage du fluide au moyen d'un premier chemin de fluide (409) ;
le au moins un premier composant semi-conducteur émetteur de lumière (101) recouvrant le premier élément de support (102) sur un côté de la première surface de support (401) ;
le premier chemin de fluide (409) étant au moins partiellement délimité par la première surface de refroidissement (402) ;
la première surface de support (401) et la première surface de refroidissement (402) étant des surfaces extérieures opposées du premier élément de support (102) ; l'élément de distribution (103) s'étendant longitudinalement dans une direction longitudinale (104) ;
la première cavité (501)
a] comprend un premier canal (503) qui s'étend longitudinalement dans la direction longitudinale (104), et
b] comprend en outre un deuxième canal (504) qui s'étend longitudinalement à partir du premier canal (503) en direction du premier élément de support (102),
le premier canal (503) et le deuxième canal (504) de la première cavité (501) étant reliés entre eux de manière à permettre le passage de fluide,
le diamètre du premier canal (503) de la première cavité (501) étant supérieur au diamètre du deuxième canal (504) de la première cavité (501) ;
la cavité supplémentaire (502)
a} comprend un premier canal (505) qui s'étend longitudinalement (104) et
b} comprend en outre un deuxième canal (506) qui s'étend longitudinalement à partir du premier canal (505) en direction du premier élément de support (102),
le premier canal (505) et le deuxième canal (506) de l'autre cavité (502) étant reliés entre eux de manière à permettre le passage de fluide,
le diamètre du premier canal (505) de la cavité supplémentaire (502) étant supérieur qu'un diamètre du deuxième canal (506) de la cavité supplémentaire (502).

7. Le procédé (600) selon la revendication 6, dans lequel la première surface de refroidissement (401) est au moins en partie une surface d'une structure de refroidissement (403) du premier élément de support (102),
dans lequel, dans l'étape A} (601) du procédé, la fourniture du premier élément de support (102) comprend la création de la structure de refroidissement (403) à l'aide d'une fraise à disque.

8. Une machine d'impression (701) comprenant la source lumineuse (100) selon l'une des revendications 1 à 5.

9. Un procédé (800) comprenant les étapes suivantes
A) la mise à disposition
I) de la source lumineuse (100) selon l'une des revendications 1 à 5, et
II) d'un objet (1002) ;
B) superposer l'objet (1002) avec une composition (1003) ; et
C) irradier la composition (1003) avec de la lumière (1004) émise par au moins un premier dispositif semi-conducteur émetteur de lumière (101).

10. Le procédé (800) selon la revendication 9, dans lequel l'étape C) comprend le durcissement de la composition (1003).
le durcissement comprenant la réduction d'une proportion d'un véhicule dans la composition (1003).

11. Un dispositif (1000) comprenant
A. la source lumineuse (100) selon l'une des revendications 1 à 5, et
B. un produit à irradier (1001),
la source lumineuse et l'objet à irradier (1001) étant agencés et conçus pour irradier l'objet à irradier (1001) avec la lumière (1003) émise par le au moins un premier composant semi-conducteur émettant de la lumière (101).

12. Un procédé (1100) comprenant les étapes suivantes
A] fournir l'agencement (1000) selon la revendication 11 ; et
B] irradier le produit à irradier (1001) avec la lumière (1004) émise par le au moins un premier composant semi-conducteur émettant de la lumière (101).

13. Une utilisation de la source lumineuse (100) selon l'une des revendications 1 à 5 pour durcir une composition (1003).

14. Une utilisation de la source lumineuse (100) selon l'une des revendications 1 à 5 dans une machine d'impression (701).
